(19) Europäisches Patentamt
European Patent Office
Office européen des brevets

(11) **EP 4 746 301 A1**

(12) **EUROPEAN PATENT APPLICATION**

(43) Date of publication:
**20.05.2026 Bulletin 2026/21**

(21) Application number: **25189702.1**

(22) Date of filing: **15.07.2025**

(51) International Patent Classification (IPC):
**H03M 13/13** (2006.01)     **G06F 11/10** (2006.01)
**H03M 13/00** (2006.01)     **H04L 1/00** (2006.01)

(52) Cooperative Patent Classification (CPC):
**H03M 13/13; G06F 11/1048; H03M 13/611;
H03M 13/63; H04L 1/0041; H04L 1/0045;
H04L 1/0057; H03M 13/6502**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **14.11.2024   KR 20240162071
02.05.2025   US 202519197429**

(71) Applicant: **Samsung Electronics Co., Ltd.
Suwon-si, Gyeonggi-do 16677 (KR)**

(72) Inventors:
• **SO, Hyejeong**
  **16677 Suwon-si (KR)**
• **SEOL, Changkyu**
  **16677 Suwon-si (KR)**
• **KIM, Jiho**
  **16677 Suwon-si (KR)**

(74) Representative: **Marks & Clerk LLP
15 Fetter Lane
London EC4A 1BW (GB)**

(54) **STORAGE DEVICE AND OPERATING METHOD OF STORAGE DEVICE**

(57)   An operating method of a storage device, including obtaining, by a memory controller, channel selection information indicating positions of data bits and shaping parity bits, generating, by the memory controller, an alignment vector by aligning the data bits and the shaping parity bits having arbitrary values based on the channel selection information, generating based on first LLR information related to the alignment vector, by the memory controller, second LLR information for a target vector, determining, by the memory controller, values of a shaping parity bits based on the target vector and the second LLR information, performing, by the memory controller, an update operation on the shaping parity bits based on the determined values, and generating, by the memory controller, a codeword with respect to the input data based on a first matrix multiplication calculation of the target vector and a first generation matrix after the update operation is performed.

FIG. 9

# Description

FIELD

Some example embodiments of the present inventive concepts described herein relate to a semiconductor memory, and more particularly, relate to a storage device including the semiconductor memory and/or an operating method of the storage device.

BACKGROUND

A storage device refers to a device, which stores data under control of a host device, such as a computer, a smartphone, a smart pad, and/or the like. The storage device includes a device, which stores data on a magnetic disk, such as a hard disk drive (HDD), and/or a device, which stores data in a semiconductor memory, in particular, a nonvolatile memory, such as a solid state drive (SSD) and/or a memory card.

The nonvolatile memory includes a read only memory (ROM), a programmable ROM (PROM), an electrically programmable ROM (EPROM), an electrically erasable and programmable ROM (EEPROM), a flash memory, a phase-change RAM (PRAM), a magnetic RAM (MRAM), a resistive RAM (RRAM), a ferroelectric RAM (FRAM), etc.

As semiconductor manufacturing technologies develop, the degree of integration and a volume of the storage device continue to increase. The high degree of integration of the storage device makes it possible to reduce costs necessary to manufacture the storage device. However, the high or higher degree of integration of the storage device may cause a scale-down and a structure change of the storage device, thereby causing various new issues. Such issues may cause damage to data stored in the storage device. Therefore, it may be advantageous to prevent and/or reduce various issues and to improve and/or increase the reliability of storage devices.

SUMMARY

Some example embodiments provide a storage device and/or an operating method of the storage device capable of reducing power consumption and improving reliability.

According to some example embodiments, an operating method of a storage device which includes a nonvolatile memory device and a memory controller configured to control the nonvolatile memory device, the method including obtaining, by the memory controller, channel selection information indicating positions of data bits included in input data and positions of shaping parity bits, generating, by the memory controller, an alignment vector by aligning the data bits and the shaping parity bits having arbitrary values based on the channel selection information, generating based on first log likelihood ratio (LLR) information related to the alignment vector, by the memory controller, second LLR information for a target vector including the shaping parity bits, determining, by the memory controller, values of the shaping parity bits based on the target vector and the second LLR information, performing, by the memory controller, an update operation on the shaping parity bits based on the determined values, and generating, by the memory controller, a codeword with respect to the input data based on a first matrix multiplication calculation of the target vector and a first generation matrix after the update operation is performed.

According to some example embodiments, an operating method of a storage device which includes a nonvolatile memory device and a memory controller configured to control the nonvolatile memory device, the method including obtaining, by the memory controller, channel selection information indicating the positions of data bits included in input data, positions of error correction code (ECC) parity bits, and positions of shaping parity bits, generating, by the memory controller, an alignment vector by aligning the data bits, the ECC parity bits, and the shaping parity bits, based on the channel selection information, determining, by the memory controller, values of the ECC parity bits, generating based on first log likelihood ratio (LLR) information related to the alignment vector, by the memory controller, second LLR information for a target vector including the shaping parity bits, determining, by the memory controller, values of the shaping parity bits, based on the target vector and the second LLR information, performing, by the memory controller, an update operation on the shaping parity bits, based on the determined values, and generating, by the memory controller, a codeword with respect to the input data, based on a first matrix multiplication calculation of the target vector and a first generation matrix after the update operation is performed.

According to some example embodiments, a storage device comprises a nonvolatile memory device; and a memory controller configured to control the nonvolatile memory device to: obtain channel selection information indicating positions of data bits included in input data and positions of shaping parity bits, generate an alignment vector by aligning the data bits and the shaping parity bits based on the channel selection information, generate, based on first log likelihood ratio (LLR) information related to the alignment vector, second LLR information for a target vector including the shaping parity bits, determine values of the shaping parity bits based on the target vector and the second LLR information, perform an update operation on the shaping parity bits based on the determined values, and generate a codeword with respect to the input data based on a first matrix multiplication calculation of the target vector and a first generation matrix.

According to some example embodiments, a storage system may comprise a host device, and a storage device including a non-volatile memory device and a memory controller configured to control the non-volatile memory device. The storage controller may be configured to receive first data as input data from the host device, obtain channel selection information indicating positions of data bits included in the input data and positions of shaping parity bits, generate an alignment vector by aligning the data bits and the shaping parity bits having arbitrary values based on the channel selection information, generate, based on first log likelihood ratio (LLR) information related to the alignment vector, second LLR information for a target vector including the shaping parity bits, determine values of the shaping parity bits based on the target vector and the second LLR information, perform an update operation on the shaping parity bits based on the determined values, generate a codeword with respect to the input data based on a first matrix multiplication calculation of the target vector and a first generation matrix after the updated operation is performed, and store data related to the codeword in the nonvolatile memory device.

According to some example embodiments, a storage device comprises a nonvolatile memory device; and a memory controller configured to control the nonvolatile memory device to: obtain channel selection information indicating positions of data bits included in input data, positions of error correction code (ECC) parity bits, and positions of shaping parity bits; generate an alignment vector by aligning the data bits, the ECC parity bits, and the shaping parity bits, based on the channel selection information; determine values of the ECC parity bits; generate based on first log likelihood ratio (LLR) information related to the alignment vector second LLR information for a target vector including the shaping parity bits; determine values of the shaping parity bits, based on the target vector and the second LLR information; perform an update operation on the shaping parity bits, based on the determined values; and generate a codeword with respect to the input data, based on a first matrix multiplication calculation of the target vector and a first generation matrix after the update operation is performed.

According to some example embodiments, a storage system may comprise a host device, and a storage device including a non-volatile memory device and a memory controller configured to control the non-volatile memory device. The storage controller may be configured to: obtain channel selection information indicating positions of data bits included in input data, positions of error correction code (ECC) parity bits, and positions of shaping parity bits; generate an alignment vector by aligning the data bits, the ECC parity bits, and the shaping parity bits, based on the channel selection information; determine values of the ECC parity bits; generate based on first log likelihood ratio (LLR) information related to the alignment vector second LLR information for a target vector including the shaping parity bits; determine values of the shaping parity bits, based on the target vector and the second LLR information; perform an update operation on the shaping parity bits, based on the determined values; and generate a codeword with respect to the input data, based on a first matrix multiplication calculation of the target vector and a first generation matrix after the update operation is performed.

At least some of the above and other features of the disclosure are set out in the claims.

BRIEF DESCRIPTION OF THE DRAWINGS

The above and other objects and features of the present inventive concepts will become apparent by describing in detail some example embodiments thereof with reference to the accompanying drawings.

FIG. 1 illustrates a storage device, according to some example embodiments.
FIG. 2 illustrates a nonvolatile memory device, according to some example embodiments.
FIG. 3 illustrates a memory block, according to some example embodiments.
FIG. 4 illustrates a memory controller, according to some example embodiments.
FIG. 5A illustrates an example of a flowchart for an operation of an encoder of the memory controller of FIG. 4 according to some example embodiments.
FIG. 5B illustrates an encoder configured to perform operations according to a flowchart of FIG. 5A according to some example embodiments.
FIG. 6 illustrates an example of an alignment vector, according to some example embodiments.
FIG. 7 illustrates an example of LLR information, according to some example embodiments.
FIG. 8 illustrates an example of a generation matrix, according to some example embodiments.
FIG. 9 illustrates an example of an operation result of a matrix multiplication calculator, according to some example embodiments.
FIG. 10 illustrates program states and a bit mapping for each program state of a nonvolatile memory device, according to some example embodiments.
FIG. 11 illustrates an example of masking data for a first shaping encoding, according to some example embodiments.
FIG. 12 illustrates an example of an alignment vector for a second shaping encoding, according to some example embodiments.
FIG. 13 illustrates an example of masking data for a second shaping encoding, according to some example embodiments.
FIG. 14 illustrates an example of an alignment vector generator, according to some example embodiments.
FIG. 15A illustrates an example of a flowchart for an operation of an encoder of the memory controller of FIG. 4 according to some example embodiments.
FIG. 15B illustrates an encoder configured to perform operations according to a flowchart of FIG. 14A according to some example embodiments.

FIG. 16 illustrates an example of an alignment vector for joint encoding, according to some example embodiments.

FIG. 17 illustrates an example for describing an operation of shaping decoding, according to some example embodiments.

FIG. 18 illustrates an example of a result of shaping decoding, according to some example embodiments.

FIG. 19 illustrates a memory system, according to some example embodiments.

FIG. 20 illustrates a memory system, according to some example embodiments.

DETAILED DESCRIPTION

Hereinafter, some example embodiments may be described in detail and clearly to such an extent that an ordinary one in the art easily implements the present inventive concepts.

Components that are described in the detailed description with reference to the terms "unit", "module", "block", "~er or ~or", etc. and function blocks illustrated in drawings will be implemented with software, hardware, or a combination thereof. For example, the software may be a machine code, firmware, an embedded code, and/or application software. For example, the hardware may include an electrical circuit, an electronic circuit, a processor, a computer, an integrated circuit, integrated circuit cores, a pressure sensor, an inertial sensor, a microelectromechanical system (MEMS), a passive element, and/or a combination thereof.

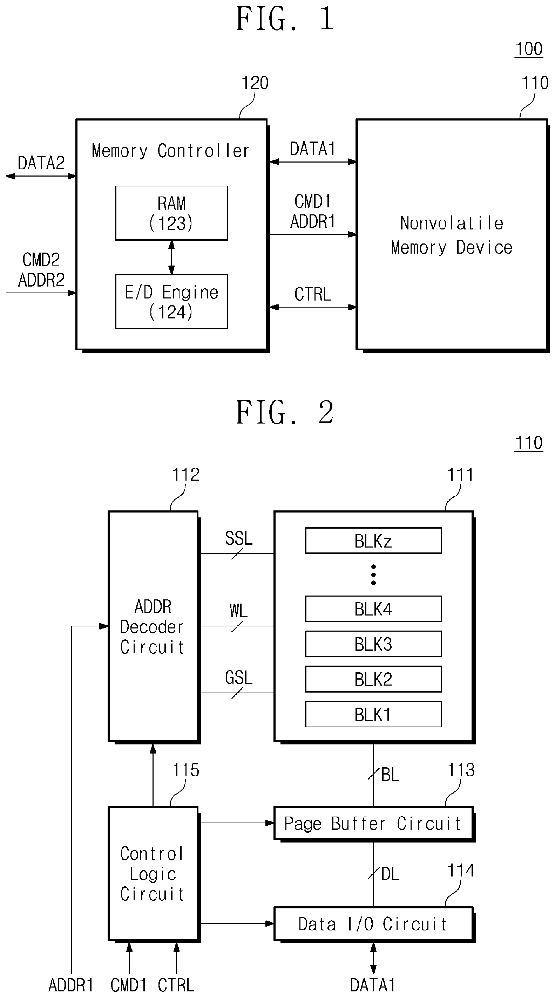

FIG. 1 illustrates a storage device, according to some example embodiments. Referring to FIG. 1, a storage device 100 may include a nonvolatile memory device 110 and a memory controller 120.

The nonvolatile memory device 110 may perform write, read, and/or erase operations under control of the memory controller 120. The nonvolatile memory device 110 may exchange first data DATA1 with the memory controller 120. For example, the nonvolatile memory device 110 may receive write data from the memory controller 120 and may write the received write data. The nonvolatile memory device 110 may perform a read operation and may output the read data to the memory controller 120.

The nonvolatile memory device 110 may receive a first command CMD1 and a first address ADDR1 from the memory controller 120. The nonvolatile memory device 110 may exchange a control signal CTRL with the memory controller 120. For example, the nonvolatile memory device 110 may receive at least one of a chip select signal nCE for selecting at least one semiconductor chip among a plurality of semiconductor chips forming the nonvolatile memory device 110, a command latch enable signal CLE for indicating that a signal received from the memory controller 120 is the first command CMD1, an address latch enable signal ALE for indicating that a signal received from the memory controller 120 is the first address ADDR1, a read enable signal nRE received from the memory controller 120 and used to align timing during a read operation, a write enable signal nWE received from the memory controller 120 and used to align timing during a write operation, and a data strobe signal DQS used to synchronize an input of the first data DATA1, from the memory controller 120. For example, the nonvolatile memory device 110 may output at least one of a ready and busy signal R/nB indicating whether the nonvolatile memory device 110 is performing a program operation, an erase operation, and/or a read operation, and the data strobe signal DQS used to synchronize an output of the first data DATA1, to the memory controller 120.

The nonvolatile memory device 110 may include a plurality of memory cells. Each of the plurality of memory cells may store two or more bits.

For example, the nonvolatile memory device 110 may include at least one of various nonvolatile memory devices such as a flash memory device, a phase change memory device, a ferroelectric memory device, a magnetic memory device, and/or a resistive memory device, but example embodiments are not limited thereto.

The memory controller 120 may be configured to control the nonvolatile memory device 110. For example, the memory controller 120 may control the nonvolatile memory device 110 to perform writing, reading, and/or erasing. The memory controller 120 may exchange the first data DATA1 and the control signal CTRL with the nonvolatile memory device 110, and may output the first command CMD1 and the first address ADDR1 to the nonvolatile memory device 110.

The memory controller 120 may control the nonvolatile memory device 110 according to the control of an external host device (not illustrated). The memory controller 120 may exchange second data DATA2 with the host device and may receive a second command CMD2 and a second address ADDR2 from the host device.

The memory controller 120 may receive the second data DATA2 from the host device, and may encode the second data DATA2 and write it as the first data DATA1 into the nonvolatile memory device 110. The memory controller 120 may receive the first data DATA1 from the nonvolatile memory device 110, and may decode the first data DATA1 and output it as the second data DATA2 to the host device. For example, the memory controller 120 may exchange the first data DATA1 with the nonvolatile memory device 110 in a first unit and may exchange second data DATA2 with the host device in a second unit different from the first unit.

The memory controller 120 may exchange the first data DATA1 with the nonvolatile memory device 110 according to a first format, and may transmit and/or send the first command CMD1 and the first address ADDR1 to the nonvolatile memory device 110. The memory controller 120 may exchange the second data DATA2 with the host device according to a second format different from the first format, and may receive the second command CMD2 and the second address ADDR2 from the host device.

The memory controller 120 may include a RAM 123 and an encoding and decoding engine (hereinafter, referred to as an "E/D engine") 124. The RAM 123 may store the second data DATA2 received from the host device. The RAM 123 may store the first data DATA1 encoded by the E/D engine 124. The RAM 123 may store the first data DATA1 received from the nonvolatile memory device 110. The RAM 123 may store the second data DATA2 decoded from the first data DATA1. The RAM 123 may function as an operating memory, a buffer memory, and/or a cache memory of the memory controller 120.

The E/D engine 124 may encode the second data DATA2 stored in the RAM 123 and may output the first data DATA1. The E/D engine 124 may decode the first data DATA1 stored in the RAM 123 and may output the second data DATA2.

For example, when writing, the second data DATA2 received from the host device may be encoded as the first data DATA1 by the E/D engine 124. The first encoded data DATA1 may be written into the nonvolatile memory device 110. When reading, the first data DATA1 read from the nonvolatile memory device 110 may be decoded as the second data DATA2 by the E/D engine 124. The second data DATA2 may be output to the host device.

In some example embodiments, the E/D engine 124 may perform shaping encoding. The shaping encoding may increase or decrease the number of bits having "1" or "0" among bits included in data. For example, the E/D engine 124 may perform the shaping encoding using shaping parity bits additionally provided in addition to the bits included in the data. Shaping parity bits may comprise parity bits provided in addition to the bits included in the data prior to shaping encoding.

In some example embodiments, the E/D engine 124 may perform a first shaping encoding. The first shaping encoding may reduce or decrease the number of logic states with a high error rate and may increase the number of other logic states. For example, the first shaping encoding may reduce or decrease the number of memory cells programmed to a target state among program states of a plurality of memory cells included in the nonvolatile memory device 110. The target state may refer to a state having the highest level of a threshold voltage distribution range among the program states. For example, the target state may refer to a program state having the highest threshold voltage distribution among the program states.

In some example embodiments, the E/D engine 124 may perform a second shaping encoding related to data bus inversion. The second shaping encoding may invert at least one bit among the bits included in the data.

The second shaping encoding may be performed to reduce power consumption due to transmission and reception of data between the nonvolatile memory device 110 and the memory controller 120.

For example, the second shaping encoding may reduce the number of bits having a specific value in data (e.g., write data) transmitted and/or sent to the nonvolatile memory device 110. For example, the second shaping encoding may reduce the number of bits having a first value (e.g., "1") in the data transmitted and/or sent to the nonvolatile memory device 110. However, example embodiments are not limited thereto, and in some example embodiments the second shaping encoding may reduce the number of bits having a second value (e.g., "0").

In some example embodiments, the E/D engine 124 may perform the shaping encoding based on a relaxed polar code and/or a modified polar code (hereinafter, referred to as the "modified polar code" for convenience of description).

FIG. 2 illustrates the nonvolatile memory device 110, according to some example embodiments. Referring to FIGS. 1 and 2, the nonvolatile memory device 110 may include a memory cell array 111, an address decoder circuit 112, a page buffer circuit 113, a data input/output circuit 114, and a control logic circuit 115.

The memory cell array 111 includes a plurality of memory blocks BLK1 to BLKz. Each of the memory blocks BLK1 to BLKz includes a plurality of memory cells. Each of the memory blocks BLK1 to BLKz may be connected to the address decoder circuit 112 through at least one ground selection line GSL, a plurality of word lines WL, and at least one string selection line SSL. Each of the memory blocks BLK1 to BLKz may be connected to the page buffer circuit 113 through a plurality of bit lines BL. The plurality of memory blocks BLK1 to BLKz may be connected in common with the plurality of bit lines BL. In other words, the plurality of memory blocks BLK1 to BLKz may share the plurality of bit lines BL. The memory cells of the plurality of memory blocks BLK1 to BLKz may have the same and/or similar structure.

The address decoder circuit 112 may be connected to the memory cell array 111 through the plurality of ground selection lines GSL, the plurality of word lines WL, and the plurality of string selection lines SSL. The address decoder circuit 112 operates under control of the control logic circuit 115. The address decoder circuit 112 may receive the first address ADDR1 from the memory controller 120. The address decoder circuit 112 may decode the received first address ADDR1 and may control voltages to be applied to the word lines WL based on the decoded address.

For example, during a program operation, the address decoder circuit 112 may apply a program voltage VGPM to a selected word line in the selected memory block indicated by the first address ADDR1, and may apply a pass voltage VPASS to unselected word lines in the selected memory block. During a read operation, the address decoder circuit 112 may apply a selection read voltage VRD to the selected word line in the selected memory block indicated by the first address ADDR1, and may apply a non-selection read voltage VREAD to unselected word lines in the selected memory block. During an erase operation, the address decoder circuit 112 may apply an erase voltage (e.g., a ground voltage) to word lines of the selected memory block that the first address ADDR1 indicates.

The page buffer circuit 113 is connected to the memory cell array 111 through the plurality of bit lines BL. The page buffer circuit 113 is connected to the data input/output circuit 114 through a plurality of data lines DL. The page buffer circuit 113 operates under control of the control logic circuit 115.

The page buffer circuit 113 may store data to be programmed in memory cells of the memory cell array 111 or read data from the memory cells. During a program operation, the page buffer circuit 113 may store data to be programmed in the memory cells. The page buffer circuit 113 may bias the plurality of bit lines BL based on the stored data. During the program operation, the page buffer circuit 113 may function as a write driver. In a read operation, the page buffer circuit 113 may sense voltages of the bit lines BL and may store the sensed result. In the read operation, the page buffer circuit 113 may function as a sense amplifier.

The data input/output circuit 114 is connected with the page buffer circuit 113 through the plurality of data lines DL. The data input/output circuit 114 may exchange the first data DATA1 with the memory controller 120.

The data input/output circuit 114 may temporarily store the first data DATA1 received from the memory controller 120. The data input/output circuit 114 may transfer the stored data to the page buffer circuit 113. The data input/output circuit 114 may temporarily store the data transferred from the page buffer circuit 113. The data input/output circuit 114 may transmit and/or send the stored data to the memory controller 120. The data input/output circuit 114 may function as a buffer memory.

The control logic circuit 115 receives the first command CMD1 and the control signal CTRL from the memory controller 120. The control logic circuit 115 may decode the received first command CMD 1 and may control overall operations of the nonvolatile memory device 110 based on the decoded command.

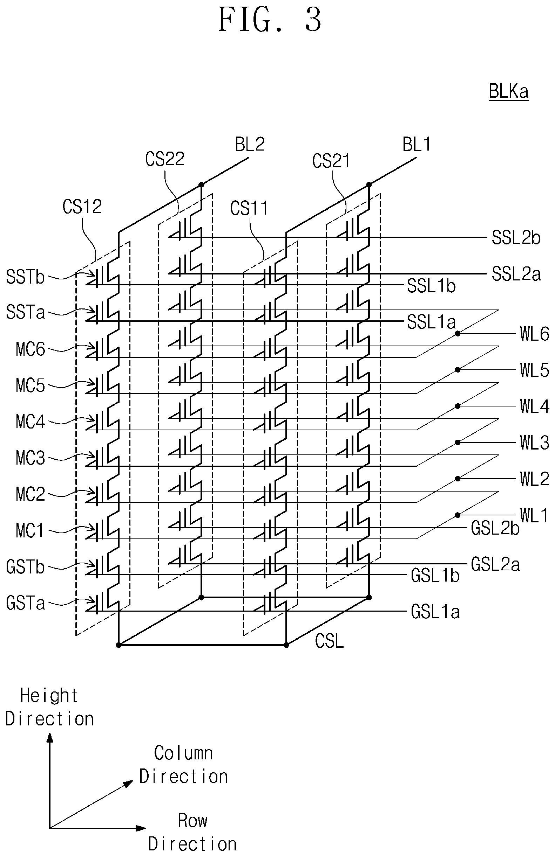

FIG. 3 is a circuit diagram illustrating a memory block BLKa, according to some example embodiments. Referring to FIG. 3, the memory block BLKa includes a plurality of cell strings CS11 to CS21 and CS12 to CS22. The plurality of cell strings CS11 to CS21 and CS12 to CS22 may be arranged along a row direction and a column direction to form rows and columns.

For example, the cell strings CS11 and CS12 arranged along the row direction may constitute a first row, and the cell strings CS21 and CS22 arranged along the row direction may constitute a second row. The cell strings CS11 and CS21 arranged along the column direction may constitute a first column, and the cell strings CS12 and CS22 arranged along the column direction may constitute a second column.

Each cell string may include a plurality of cell transistors. The plurality of cell transistors include ground selection transistors GSTa and GSTb, memory cells MC1 to MC6, and string selection transistors SSTa and SSTb. The ground selection transistors GSTa and GSTb, the memory cells MC1 to MC6, the string selection transistors SSTa and SSTb in each cell string may be stacked in a height direction perpendicular to a plane (e.g., a plane on a substrate of the memory block BLKa) on which the cell strings CS11, CS21, CS12, and CS22 are arranged along the rows and the columns.

Each cell transistor may be a charge trap type cell transistor of which the threshold voltage changes depending on the amount of charges trapped in an insulating layer thereof.

The lowermost ground selection transistors GSTa may be connected in common to a common source line CSL.

The ground selection transistors GSTa and GSTb of the plurality of cell strings CS11, CS21, CS12, and CS22 may be connected in common to the ground selection line GSL.

In some example embodiments, ground selection transistors of the same height (or order) may be connected to the same and/or similar ground selection line, and ground selection transistors of different heights (or orders) may be connected to different ground selection lines. For example, the ground selection transistors GSTa of a first height may be connected in common to a first ground selection line, and the second ground selection transistors GSTb of a second height may be connected in common to a second ground selection line.

For example, ground selection transistors of the same row may be connected to the same and/or similar ground selection line, and ground selection transistors of different rows may be connected to different ground selection lines. For example, the ground selection transistors GSTa and GSTb of the cell strings CS11 and CS12 in the first row may be connected to a first ground selection line, and the ground selection transistors GSTa and GSTb of the cell strings CS21 and CS22 in the second row may be connected to a second ground selection line.

Memory cells placed at the same and/or similar height (or order) from the substrate (or the ground selection transistor GSTa or GSTb) may be connected in common to one word line, and memory cells placed at different heights (or, orders) may be respectively connected to different word lines WL1 to WL6. For example, the memory cells MC1 are connected in common to the word line WL1. The memory cells MC2 are connected in common to the word line WL2. The memory cells MC3 are connected in common to the word line WL3. The memory cells MC4 are connected in common to the word line WL4. The memory cells MC5 are connected in common to the word line WL5. The memory cells MC6 are connected in common to the word line WL6.

In the first string selection transistors SSTa of the plurality of cell strings CS11, CS21, CS12, and CS22 which have the same and/or similar height (or order), the first string selection transistors SSTa in different rows are respectively connected to different string selection lines SSL1a and SSL2a. For example, the first string selection transistors SSTa of the cell strings CS11 and CS12 are connected in common to the string selection line SSL1a. The first string selection transistors SSTa of the cell strings CS21 and CS22 are connected in common to the string selection line SSL2a.

In the second string selection transistors SSTb of the plurality of cell strings CS11, CS21, CS12, and CS22 which have the same and/or similar height (or order), the second string selection transistors SSTb in different rows are respectively connected to different string selection lines SSL1b and SSL2b. For example, the second string selection transistors SSTb of the cell strings CS11 and CS12 are connected in common to the string selection line SSL1b. The second string selection transistors SSTb of the cell strings CS21 and CS22 are connected in common to the string selection line SSL2b.

For example, cell strings in different rows are connected to different string selection lines. String selection transistors, which have the same height (or order), from among cell strings in the same row are connected to the same string selection line. String selection transistors, which have different heights (or orders), from among cell strings in the same row are connected to different string selection lines.

In some example embodiments, string selection transistors of cell strings in the same row may be connected in common to a string selection line. For example, the string selection transistors SSTa and SSTb of the cell strings CS11 and CS12 in the first row may be connected in common to a string selection line. The string selection transistors SSTa and SSTb of the cell strings CS21 and CS22 in the second row may be connected in common to a string selection line.

Columns of the plurality of cell strings CS11, CS21, CS12, and CS22 may be connected to different bit lines BL1 and BL2. For example, the string selection transistors SSTb of the cell strings CS11 and CS21 in the first column may be connected in common to the bit line BL1. The string selection transistors SSTb of the cell strings CS12 and CS22 in the second column may be connected in common to the bit line BL2.

The cell strings CS11 and C12 may compose a first plane. The cell strings CS21 and C22 may compose a second plane.

In the memory block BLKa, the write and read operations may be performed in units of a row. For example, one plane of the memory block BLKa may be selected by the string selection lines SSL1a, SSL1b, SSL2a, and SSL2b. The cell strings CS11 and CS12 in a first plane may be connected to the bit lines BL1 and BL2 when a turn-on voltage is supplied to the string selection lines SSL1a and SSL1b and a turn-off voltage is supplied to the string selection lines SSL2a and SSL2b. For example, the first plane may be selected. The cell strings CS21 and CS22 in a second plane may be connected to the bit lines BL1 and BL2 when the turn-on voltage is supplied to the string selection lines SSL2a and SSL2b and the turn-off voltage is supplied to the string selection lines SSL1a and SSL1b. For example, the second plane may be selected. In the selected plane, a row of memory cells MC may be selected by the word lines WL1 to WL6. In the selected row, the write operation or the read operation may be performed.

In the memory block BLKa, the erase operation may be performed for each memory block or for each sub-block. When the erase operation is performed for each memory block, all memory cells MCs in the memory block BLKa may be erased. When the erase operation is performed for each sub-block, some of memory cells MCs in the memory block BLKa may be erased, and the remaining memory cells MCs thereof may be erase-inhibited. A low voltage (e.g., a ground voltage) may be supplied to a word line connected to memory cells to be erased, and a word line connected to erase-inhibited memory cells may be floated.

The memory block BLKa illustrated in FIG. 3 is provided as an example. However, example embodiments are not limited to the memory block BLKa illustrated in FIG. 3. For example, the number of rows of cell strings may increase and/or decrease. As the number of rows of cell strings varies, the number of string selection lines or ground select lines connected to the rows of cell strings and the number of cell strings connected to a bit line may also vary.

For example, the number of columns of cell strings may increase and/or decrease. As the number of columns of cell strings varies, the number of bit lines connected to columns of cell strings and the number of cell strings connected to a string selection line may also vary.

For example, a height of the cell strings may increase and/or decrease. For example, the number of ground selection transistors, memory cells, and/or string selection transistors that are stacked in each cell string may increase and/or decrease.

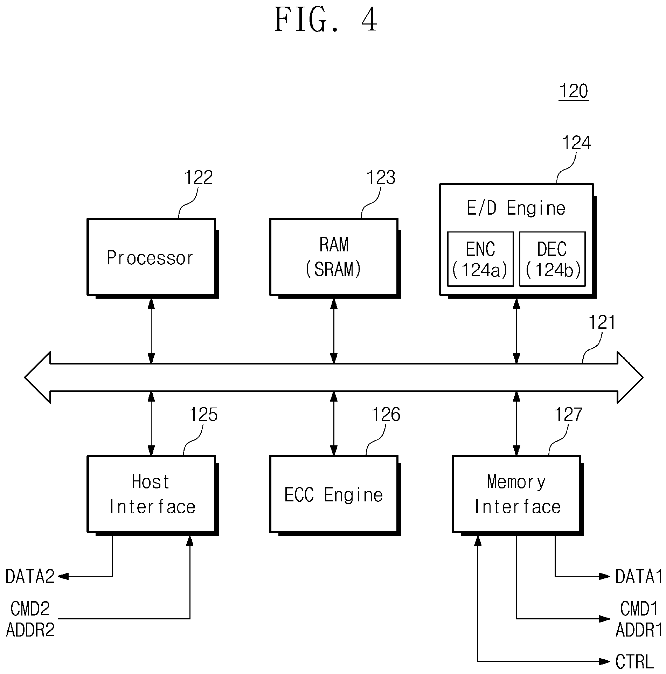

FIG. 4 illustrates a memory controller, according to some example embodiments. Referring to FIG. 4, the memory controller 120 may include a bus 121, a processor 122, the RAM 123, the E/D engine 124, a host interface 125, an ECC engine 126, and a memory interface 127.

The bus 121 is configured to provide a channel between the components of the memory controller 120.

The processor 122 may control overall operations of the memory controller 120 and may perform a logical calculation. The processor 122 may communicate with an external host device through the host interface 125. The processor 122 may receive a clock signal CLK, the second command CMD2, and the second address ADDR2 through the host interface 125. The processor 122 may exchange the second data DATA2 with an external host device through the host interface 125. The processor 122 may exchange the first data DATA1 and the control signal CTRL with the nonvolatile memory device 110 through the memory interface 127. The processor 122 may output the first command CMD1 and the first address ADDR1 to the nonvolatile memory device 110.

The processor 122 may store the second command CMD2 or the second address ADDR2 received through the host interface 125 in the RAM 123. The processor 122 may store the second data DATA2 received through the host interface 125 in the RAM 123. The processor 122 may generate the first command CMD1 depending on the second command CMD2 or the second address ADDR2 stored in the RAM 123, and may output the generated first command CMD1 and the generated first address ADDR1 through the memory interface 127. The processor 122 may output the first data DATA1 stored in the RAM 123 through the memory interface 127. The processor 122 may store the first data DATA1 received through the memory interface 127 in the RAM 123. The processor 122 may output the second data DATA2 stored in the RAM 123 through the host interface 125. For example, the processor 122 includes a DMA (Direct Memory Access) circuit and may output data using the DMA circuit.

The RAM 123 may be used as a working memory, a cache memory, and/or a buffer memory of the processor 122. The RAM 123 may store codes and/or commands that the processor 122 executes. The RAM 123 may store data that are processed by the processor 122. The RAM 123 may include a static RAM (SRAM).

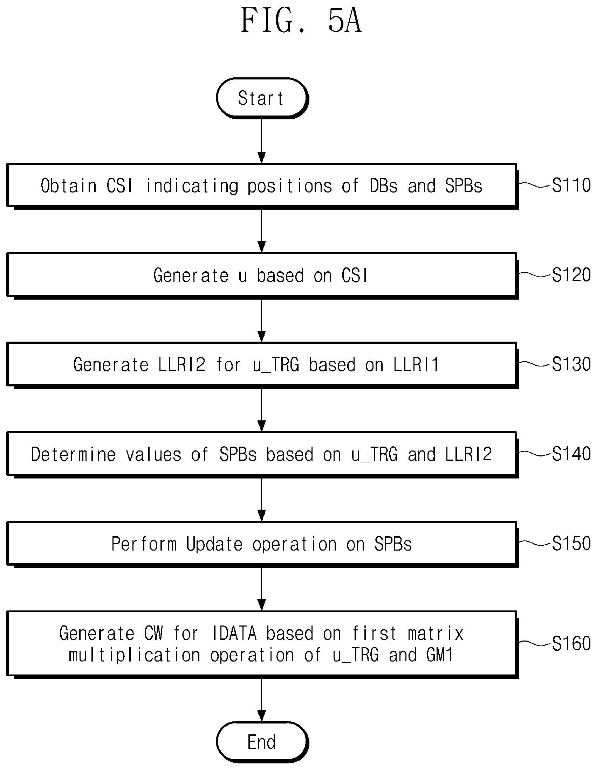

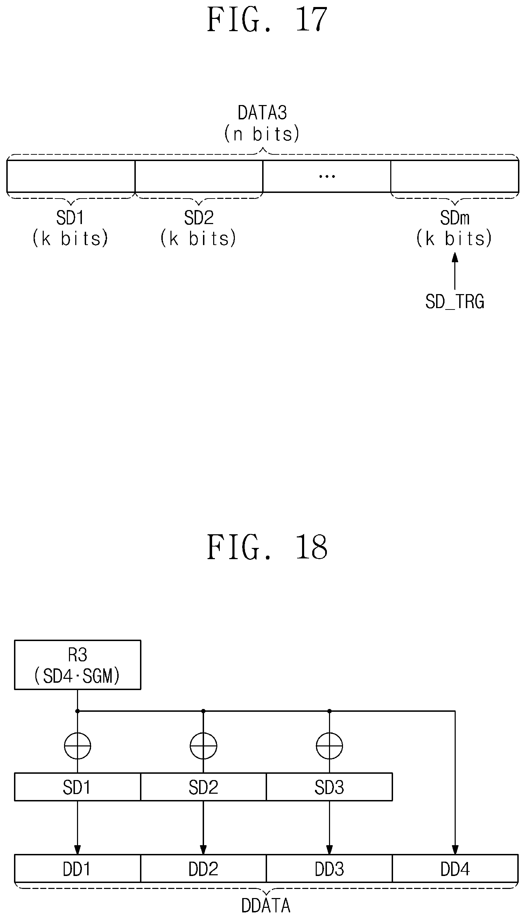

The E/D engine 124 may include an encoder (ENC) 124a and a decoder (DEC) 124b. The encoder 124a may read the second data DATA2 stored in the RAM 123, may shape-encode the read second data DATA2 to generate the first data DATA1, and may store the generated first data DATA1 in the RAM 123. The decoder 124b may read first data DATA1 stored in the RAM 123, may shape-decode the read first data DATA1 to generate the second data DATA2, and may store the generated second data DATA2 in the RAM 123. The E/D engine 124 may store information required and/or advantageous for performing shaping encoding and/or shaping decoding in RAM 123 and/or may read information from RAM 123. The E/D engine 124 may be implemented as hardware and/or software driven by the processor 122. The shaping encoding will be described in more detail with reference to FIGS. 5A to 16, and the shaping decoding will be described in more detail with reference to FIGS. 17 and 18.

In some example embodiments, the encoder 124a and the decoder 124b may operate in conjunction with each other. For example, the decoder 124b may share the operation information used by the encoder 124a. In FIG. 4, the encoder 124a and the decoder 124b are implemented as separate components, but example embodiments are not limited thereto, and in some example embodiments the encoder 124a and the decoder 124b may share some components.

The host interface 125 is configured to communicate with an external host device under the control of the processor 122. The host interface 125 may be configured to communicate using at least one of various communication manners such as a universal serial bus (USB) manner, a serial AT attachment (SATA) manner, a serial attached SCSI (SAS) manner, a high speed interchip (HSIC) manner, a small computer system interface (SCSI) manner, a firewire manner, a peripheral component interconnection (PCI) manner, a PCI express (PCIe) manner, a nonvolatile memory express (NVMe) manner, a universal flash storage (UFS) manner, a secure digital (SD) manner, a multimedia card (MMC) manner, and/or an embedded MMC (eMMC) manner.

The ECC engine 126 may perform error correction encoding. The ECC engine 126 may generate an ECC parity for performing the error correction encoding based on data to be output to the memory interface 127. By performing the error correction encoding, the ECC engine 126 may add the ECC parity to the data to be output. The ECC parity includes one or more bits and may provide an error correction function. Data encoded by the ECC engine 126 may be transmitted and/or sent to the nonvolatile memory device 110.

In some example embodiments, the ECC engine 126 may perform the error correction encoding on data on which the shaping encoding is performed.

The ECC engine 126 may perform the error correction decoding on data received through the memory interface 127. By performing the error correction decoding using the ECC parity of data, the ECC engine 126 may correct errors from received data.

The ECC engine 126 may store information necessary when performing error correction encoding and/or error correction decoding in RAM 123 and/or may read information from RAM 123. The ECC engine 126 may be implemented as hardware and/or software driven by the processor 122.

The memory interface 127 is configured to communicate with the nonvolatile memory device 110 under the control of the processor 122.

In some example embodiments, the processor 122 may control the memory controller 120 using codes. The processor 122 may load codes from nonvolatile memory (e.g., Read Only Memory) provided inside the memory controller 120. In some example embodiments, the processor 122 may load codes received from the memory interface 127.

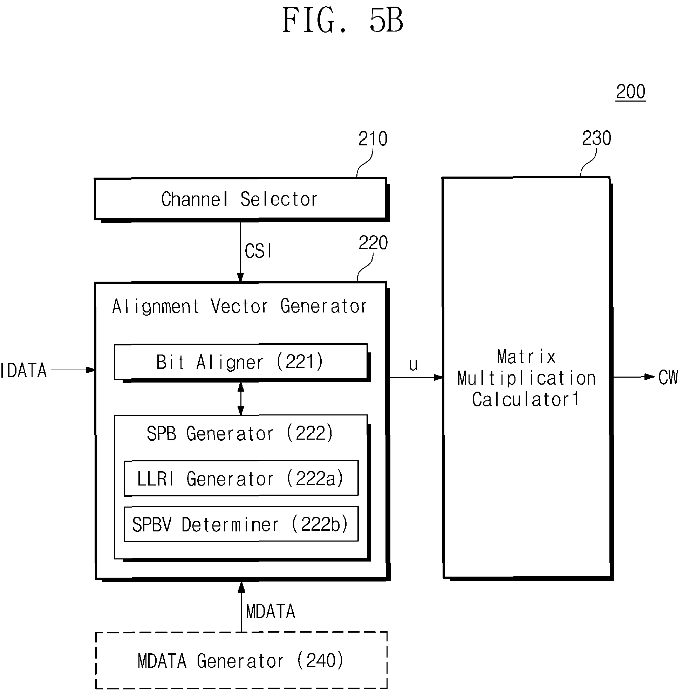

FIG. 5A illustrates an example of a flowchart for an operation of an encoder of the memory controller of FIG. 4 according to some example embodiments. FIG. 5B illustrates an encoder configured to perform operations according to a flowchart of FIG. 5A according to some example embodiments.

In the following, to briefly and clearly describe some example embodiments of the present inventive concepts, some data values and/or some bit values are described as being at a specific level and/or a specific bit level (e.g., "1" or "0"). However, the scope of the present inventive concepts are not limited thereto, and in some example embodiments of the present inventive concepts various data values and/or various bit values used for the present inventive concepts may be variously modified depending on the implementation method.

Referring to FIGS. 5A and 5B, in operation S110, an encoder 200 may obtain channel selection information CSI indicating positions of data bits DBs of input data IDATA and positions of shaping parity bits SPBs. For example, a channel selector 210 of FIG. 5B may distinguish a plurality of channels into good channels and bad channels through channel polarization based on polar codes. In some example embodiments, a channel may represent a path along which a specific bit is transmitted and/or sent. A good channel may represent a channel with a low error probability and/or high reliability. The good channel may be used for the shaping parity bits SPBs, and the bad channel may be used for the data bits DBs of the input data IDATA. Positions of the data bits DBs and positions of the shaping parity bits SPBs may refer to the channels on which the data bits DBs and the shaping parity bits SPBs, respectively, are transmitted and/or sent.

In some example embodiments, when a first shaping encoding is performed, the shaping parity bit SPB may be a VSS (e.g., voltage) shaping parity bit VSPB. In some example embodiments, when a second shaping encoding is performed, the shaping parity bit SPB may be a data bus inversion (DBI) shaping parity bit DSPB.

In some example embodiments, the channel selector 210 may determine the channel selection information CSI based on a bhattacharyya parameter. The bhattacharyya parameter may be a parameter related to the reliability of a channel. The channel selector 210 may determine the positions of the shaping parity bits SPBs based on an order in which the values of the bhattacharyya parameter are aligned in ascending order.

In some example embodiments, the channel selector 210 may determine the channel selection information CSI such that the shaping parity bits SPBs are aligned to specific, or alternatively desired positions.

In operation S120, the encoder 200 may generate an alignment vector "u" by aligning the data bits DBs and the shaping parity bits SPBs based on the channel selection information CSI. For example, a bit aligner 221 of FIG. 5B may receive the shaping parity bits SPBs having initial values from a shaping parity bit generator 222. In some example embodiments, each of the initial values may be an arbitrary value. The bit aligner 221 may generate the alignment vector "u" by aligning the data bits DBs having specific values and the shaping parity bits SPBs having the initial values.

In operation S130, the encoder 200 may generate second LLR (log likelihood ratio) information LLRI2 for a target vector u_TRG including the shaping parity bits SPBs based on first LLR (log likelihood ratio) information LLRI1 related to the alignment vector "u". The target vector u_TRG is a part of the alignment vector "u" and may include the shaping parity bits SPBs. Each of the first LLR information LLRI1 and the second LLR information LLRI2 may include a different number of LLR values. In some example embodiments, the LLR value may be a value obtained by taking the log with respect to the ratio of the probability that a bit included in the data will correspond to "1" or "0". In other words, the LLR value may indicate information and/or a probability value regarding the probability that a bit included in the data will be "0" or "1".

For example, an LLR information (LLRI) generator 222a of FIG. 5B may receive the alignment vector "u" from the bit aligner 221. In some example embodiments, the shaping parity bits SPBs included in the alignment vector "u" may have arbitrary values. The LLR information generator 222a may generate LLR values included in the second LLR information LLRI2 based on accumulating the LLR values included in the first LLR information LLRI1. For example, the LLR information generator 222a may generate the second LLR information LLRI2 including the first LLR information LLRI1 based on an accumulation calculation.

In some example embodiments, the LLR values included in the first LLR information LLRI1 may correspond to the bits included in the alignment vector "u". For example, the number of LLR values included in the first LLR information LLRI1 may be the same as the number of bits included in the alignment vector "u". In some example embodiments, the LLR values included in the second LLR information LLRI2 may correspond to bits included in the target vector u_TRG. For example, the number of LLR values included in the second LLR information LLRI2 may be the same as the number of bits included in the target vector u_TRG.

In some example embodiments, the LLR information generator 222a may obtain the first LLR information LLRI1 based on the alignment vector "u".

In operation S140, the encoder 200 may determine values of the shaping parity bits SPBs based on the target vector u_TRG and the second LLR information LLRI2. For example, a shaping parity bit value (SPBV) determiner 222b of FIG. 5B may determine the values of the shaping parity bits SPBs based on the target vector u_TRG and the second LLR information LLRI2.

For example, the shaping parity bit value (SPBV) determiner 222b may determine the values of the shaping parity bits SPBs from the target vector u_TRG and the second LLR information LLRI2 using a parity value search algorithm. In some example embodiments, the shaping parity bit value determiner 222b may determine the values of the shaping parity bits SPBs using a polar decoding algorithm. For example, the shaping parity bit value determiner 222b may determine the values of the shaping parity bits SPBs using an SC (successive cancellation) algorithm, a List SC (list successive cancellation) algorithm, and/or a Brute Force Search algorithm, etc.

In operation S150, the encoder 200 may perform an update operation on the shaping parity bits SPBs based on the determined values. For example, the bit aligner 221 of FIG. 5B may receive the determined values from the shaping parity bit value determiner 222b. The bit aligner 221 may perform an update operation on the shaping parity bits SPBs based on the determined values. As a result of the performance, the values of the shaping parity bits SPBs may be updated from the initial values to the determined values.

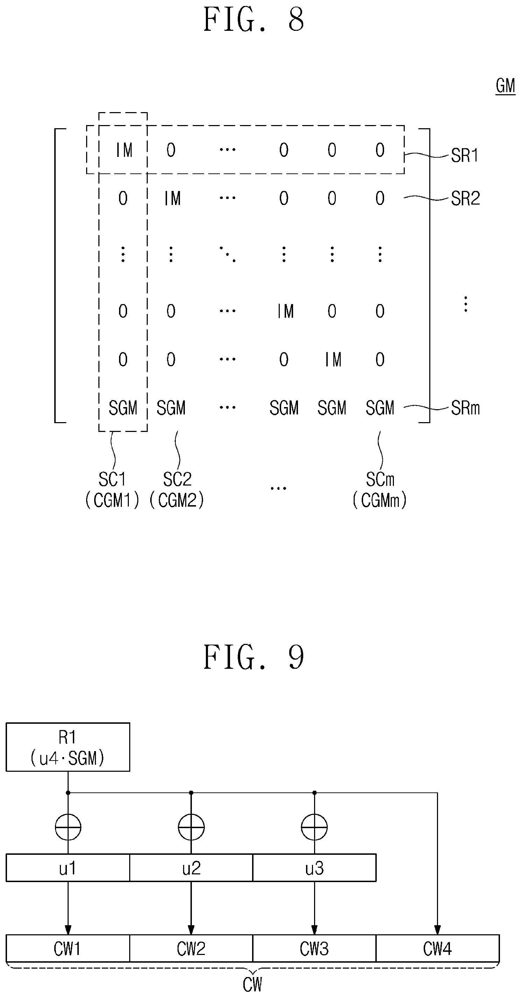

In operation S160, after the update operation, the encoder 200 may generate a codeword CW with respect to the alignment vector "u" based on a first matrix multiplication calculation of the target vector u_TRG and a first generation matrix GM1 for IDATA. For example, a first matrix multiplication calculator 230 of FIG. 5B may receive the alignment vector "u" from an alignment vector generator 220 after the update operation. The first matrix multiplication calculator 230 may generate the codeword CW with respect to the alignment vector "u" based on the first matrix multiplication calculation of the target vector u_TRG which is a part of the alignment vector "u" and the first generation matrix GM1. The first generation matrix GM1 may refer to a sub-generation matrix SGM included in a generation matrix GM based on a modified polar code. Operation S160 will be described in more detail in FIGS. 8 and 9.

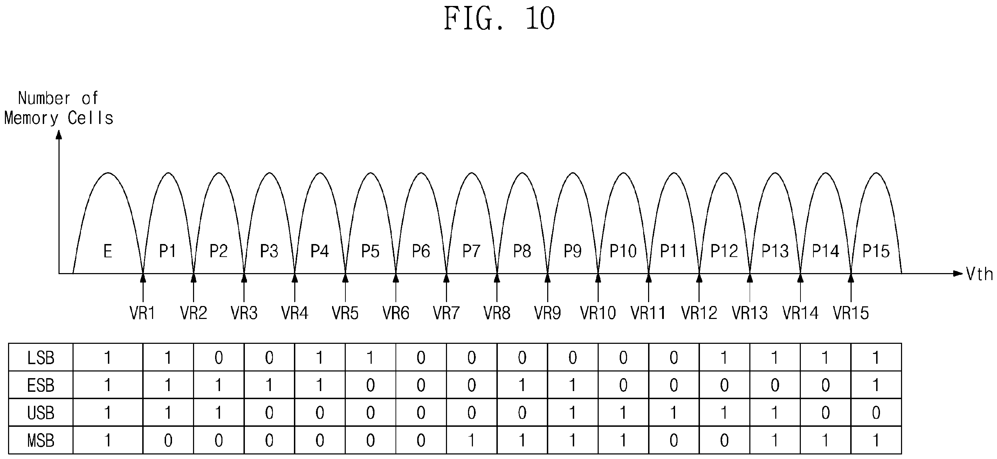

In some example embodiments, the encoder 200 may further include a masking data generator 240. The masking data generator 240 may generate masking data MDATA. The masking data MDATA may represent data to be referenced during a shaping encoding. The masking data generator 240 may update the masking data MDATA. The masking data MDATA will be described in more detail with reference to FIGS. 10, 11, and 13.

In some example embodiments, when the masking data MDATA exists, in operation S130, the LLR information generator 222a may obtain the first LLR information LLRI1 based on the alignment vector "u" and the masking data MDATA received from the masking data generator 240. For example, the LLR information generator 222a may obtain the first LLR information LLRI1 whose LLR value corresponding to a bit having a value of "0" among the masking data MDATA is "0".

In some example embodiments, when the masking data MDATA exists, in operation S140, the shaping parity bit value determiner 222b may determine the values of the shaping parity bits SPBs based on the target vector u_TRG, the second LLR information LLRI2, and the masking data MDATA.

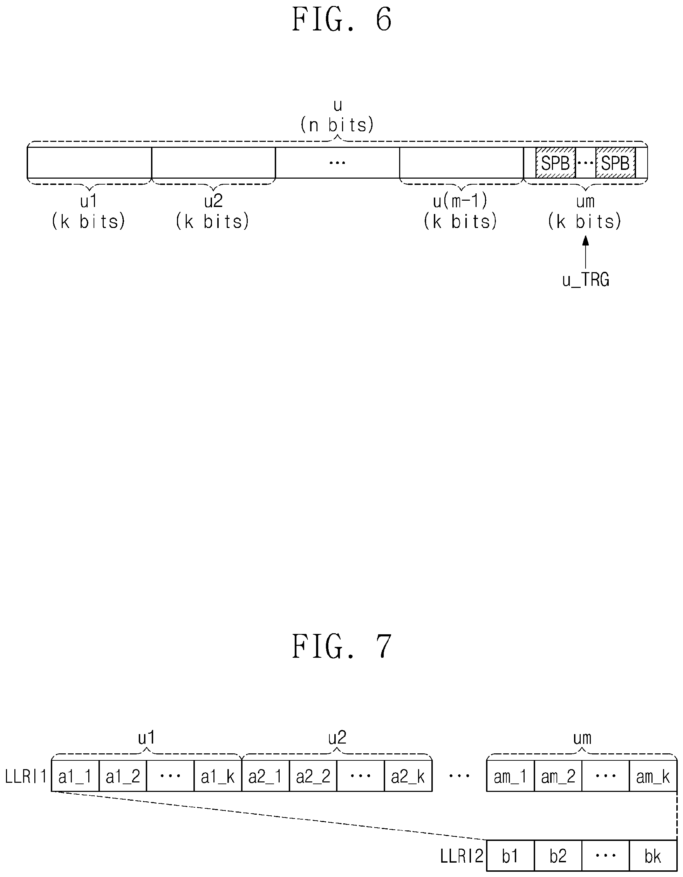

FIG. 6 illustrates an example of an alignment vector, according to some example embodiments. In FIG. 6, it is assumed that the alignment vector "u" is the alignment vector "u" before the update operation for the shaping parity bits SPBs is performed.

Referring to FIG. 6, the alignment vector "u" may include "n" bits (where "n" is a natural number greater than "1"). The alignment vector "u" may include first to m-th sub-vectors u1 to um (where "m" is a natural number greater than "1" and less than "n"). Each of the first to m-th sub-vectors u1 to um may include "k" bits (where "k" is a natural number greater than "1" and less than "n").

The first to m-th sub-vectors u1 to um may be arranged sequentially in the row direction within the alignment vector "u". The m-th sub-vector um arranged last among the first to m-th sub-vectors u1 to um may include at least one shaping parity bit SPB. In some example embodiments, the target vector u_TRG may indicate the m-th sub-vector um arranged last among the first to m-th sub-vectors u1 to um. In other words, the target vector u_TRG may indicate a sub-vector including at least one shaping parity bit.

In some example embodiments, the number of sub-vectors u1 to um may correspond to an exponent of "2".

In some example embodiments, the number of bits included in each of the sub-vectors u1 to um may be determined based on the channel selection information CSI. For example, the length of the target vector u_TRG including the shaping parity bits SPBs may be determined based on at least some of the channels classified as good channels through the channel polarization. For example, when there are many channels determined as good channels, the number of shaping parity bits SPBs may increase, and the length of the target vector u_TRG may increase. When there are few channels determined as good channels, the number of shaping parity bits SPBs may decrease, and the length of the target vector u_TRG may decrease.

In some example embodiments, the alignment vector "u" may be referred to as a row matrix having a size of "1" x "n". In some example embodiments, each of the first to m-th sub-vectors u1 to um may be referred to as a row matrix having a size of "1" x "k".

In some example embodiments, the alignment vector "u" may be referred to as a reduced row matrix having a size of "1" x "m". For example, the alignment vector "u" may be referred to as a reduced row matrix including the first row and first to m-th sub-columns. Each of the first to m-th sub-columns may include "k" columns.

FIG. 7 illustrates an example of LLR information, according to some example embodiments. Referring to FIG. 5B and FIG. 7, the LLR information generator 222a may generate the second LLR information LLRI2 for the target vector u_TRG based on the first LLR information LLRI1 related to the alignment vector "u".

The first LLR information LLRI1 may include LLR values corresponding to bits included in the alignment vector "u". The number of LLR values included in the first LLR information LLRI1 may be the same as the number of bits included in the alignment vector "u". For example, the number of LLR values included in the first LLR information LLRI1 may be "m" x "k". The second LLR information LLRI2 may include LLR values corresponding to bits included in the target vector u_TRG. The number of LLR values included in the second LLR information LLRI2 may be the same as the number of bits included in the target vector u_TRG. For example, the number of LLR values included in the second LLR information LLRI2 may be "k".

In some example embodiments, the LLR information generator 222a may generate LLR values included in the second LLR information based on accumulating LLR values included in the first LLR information. For example, the LLR information generator 222a may generate the second LLR information LLRI2 including the first LLR information LLRI1 based on the accumulation calculation.

For example, the LLR information generator 222a may generate an LLR value b1 corresponding to a first bit of the target vector u_TRG by accumulating LLR values a1_1, a2_1, ..., and am_1 corresponding to first bits of the first to m-th sub-vectors u1 to um. The LLR information generator 222a may generate an LLR value b2 corresponding to a second bit of the target vector u_TRG by accumulating LLR values a1_2, a2_2, ..., and am_2 corresponding to second bits of the first to m-th sub-vectors u1 to um. Likewise, the LLR information generator 222a may generate an LLR value bk corresponding to a k-th bit of the target vector u_TRG by accumulating LLR values a1_k, a2_k, ..., and am_k corresponding to k-th bits of the first to m-th sub-vectors u1 to um. However, example embodiments are not limited thereto, and in some example embodiments the LLR information generator 222a may generate the second LLR information LLRI2 including the first LLR information LLRI1 through various accumulation calculations.

FIG. 8 illustrates an example of a generation matrix, according to some example embodiments. Referring to FIGS. 5B, 6, and 8, the first matrix multiplication calculator 230 may generate the codeword CW for the alignment vector "u" through a second matrix multiplication calculation of the alignment vector "u" and the generation matrix GM. In some example embodiments, the generation matrix GM may be based on a modified polar code.

The generation matrix GM may have a size of ("m" x "k") x ("m" x "k"). For example, the generation matrix GM may have a size of "n" x "n". In some example embodiments, the generation matrix GM may be expressed as a reduced matrix having a size of "m" x "m". For example, the generation matrix GM may be expressed as a reduced matrix including first to m-th sub-rows SR1 to SRm and first to m-th sub-columns SC1 to SCm. Each of the first to m-th sub-rows SR1 to SRm may include "k" rows, and each of the first to m-th sub-columns SC1 to SCm may include "k" columns.

The generation matrix GM may include a plurality of column generation matrices CGM1 to CGMm. Each of the plurality of column generation matrices CGM1 to CGMm may have a size of "m" x "1". The first column generation matrix CGM1 may correspond to the first sub-column SC1 among the first to m-th sub-columns SC1 to SCm of the generation matrix GM. The second column generation matrix CGM2 may correspond to the second sub-column SC2 among the first to m-th sub-columns SC1 to SCm of the generation matrix GM. As in the above description, the m-th column generation matrix CGMm may correspond to the m-th sub-column SCm among the first to m-th sub-columns SC1 to SCm of the generation matrix GM.

The generation matrix GM may include diagonal elements and lowest row elements, and the remaining elements may have zero values.

For example, the first column generation matrix CGM1 may include first to m-th elements CGM1e1 to CGM1em. The first element CGM1e1 may have a unit value. The m-th element CGM1em may have a generated value. In some example embodiments, the remaining elements may have a zero value.

The second column generation matrix CGM2 may include first to m-th elements CGM2e1 to CGM2em. The second element CGM2e2 may have a unit value. The m-th element CGM2em may have a generated value. In some example embodiments, the remaining elements may have a zero value.

As in the above description, in some example embodiments, the (m-1)-th column generation matrix CGM(m-1) may include first to m-th elements CGM(m-1)e1 to CGM(m-1)em. The (m-1)-th element CGM(m-1)e(m-1) may have a unit value. The m-th element CGM(m-1)em may have a generated value. In some example embodiments, the remaining elements may have a zero value.

Meanwhile, the m-th column generation matrix CGMm may include first to m-th elements CGMme1 to CGMmem. The m-th element CGMmem may have a generated value. In some example embodiments, the remaining elements may have a zero value.

In some example embodiments, the unit value of the generation matrix GM may be an identity matrix (IM) of size "k" x "k", the generated value of the generation matrix GM may be the sub-generation matrix SGM of size "k" x "k", and the zero value of the generation matrix GM may be a zero matrix of size "k" x "k".

In some example embodiments, the sub-generation matrix SGM may be expressed as Equation 1 below.

[Equation 1]

$$G_k = F^{\otimes \log_2 k}$$

$$F = \begin{bmatrix} 1 & 0 \\ 1 & 1 \end{bmatrix}$$

In Equation 1, $G_k$ may refer to a sub-generation matrix, "F" may refer to a kernel matrix, $\otimes$ may refer to a Kronecker power calculation, and "k" may refer to the number of bits included in each of the sub-vectors.

According to some example embodiments, the result of the second matrix multiplication calculation of the alignment vector "u" and the generation matrix GM may be the same as the result of performing a logical calculation of each of the first to (m-1)-th sub-vectors u1 to u(m-1) and the result of the first matrix multiplication calculation of the m-th sub-vector um, which is the target vector u_TRG, and the sub-generation matrix SGM. In other words, when the second matrix multiplication calculation is performed using the modified polar code-based generation matrix GM according to some example embodiments, the codeword for the alignment vector "u" may be generated with a small amount of computation.

FIG. 9 illustrates an example of an operation result of a matrix multiplication calculator, according to some example embodiments. In FIG. 9, it is assumed that the alignment vector "u" includes the first to fourth sub-vectors u1 to u4.

Referring to FIGS. 5B, 6, 8, and 9, the first matrix multiplication calculator 230 may generate the codeword CW for the alignment vector "u" based on the first matrix multiplication calculation of the fourth sub-vector u4, which is the target vector u_TRG, and the sub-generation matrix SGM. The codeword CW may include first to fourth codewords CW1 to CW4.

For example, the first codeword CW1 may be obtained by a logical calculation of a result R1 of the first matrix multiplication calculation of the fourth sub-vector u4 and the sub-generation matrix SGM and the first sub-vector u1. The second codeword CW2 may be obtained by a logical calculation of the result R1 of the first matrix multiplication calculation and the second sub-vector u2. The third codeword CW3 may be obtained by a logical calculation of the result R1 of the first matrix multiplication calculation and the third sub-vector u3. The fourth codeword CW4 may be the result R1 of the first matrix multiplication calculation.

In some example embodiments, the logical calculation may represent an XOR logical calculation.

As illustrated in FIG. 9, the first matrix multiplication calculator 230 may generate the codeword CW for the alignment vector "u" based on the first matrix multiplication calculation R1 of the target vector u_TRG and the sub-generation matrix SGM, and a logical calculation of each of the remaining sub-vectors u1 to u3 excluding the target vector u_TRG among the plurality of sub-vectors u1 to u4 and the result R1 of the first matrix multiplication calculation.

FIG. 10 illustrates program states and a bit mapping for each program state of a nonvolatile memory device, according to some example embodiments. In an upper graph of FIG. 10, a horizontal axis indicates a threshold voltage Vth of memory cells, and a vertical axis indicates the number of memory cells. A table at a bottom of FIG. 10 illustrates bit patterns BP associated with an erase state "E" and first to fifteenth program states P1 to P15. For example, in FIG. 10, it is assumed that four bits are programmed in one memory cell. However, example embodiments are not limited thereto, and may be extended and applied to program "N" bits (where "N" is a positive integer) in one memory cell.

Referring to FIGS. 4 and 10, four bits programmed in one memory cell may have 16 different patterns corresponding to "2" to the power of "4". Sixteen different patterns may be mapped to the erase state "E" and the first to fifteenth program states P1 to P15, respectively. The erase state "E" and the first to fifteenth program states P1 to P15 may be respectively distinguished by threshold voltages Vth of the memory cells MC.

For example, the memory cells MC of which the threshold voltages are less than a first read voltage VR1 may be determined as having the erase state "E". The memory cells MC of which the threshold voltages are greater than the first read voltage VR1 and less than a second read voltage VR2 may be determined as being in the first program state P1. Likewise, the memory cells MC of which the threshold voltages are greater than a k-th read voltage VRk (where "k" is an integer which is greater than or equal to "1" and less than "15") and less than a (k+1)-th read voltage VRk+1 may be determined as being in the k-th program state Pk. The memory cells MC of which the threshold voltages are greater than a fifteenth read voltage VR15 may be determined as being in the fifteenth program state P15.

In FIG. 10, four bits may be programmed in each memory cell. The four bits may be referred to as an LSB, an ESB, a USB, and an MSB, respectively. The LSB may mean the least significant bit, the ESB may mean the next least significant bit, the USB may mean the next most significant bit, and the MSB may mean the most significant bit.

As illustrated in FIG. 10, a bit pattern of the erase state "E" may be "1111", a bit pattern of the first program state P1 may be "1110", a bit pattern of the second program state P2 may be "0110", a bit pattern of the third program state P3 may be "0100", a bit pattern of the fourth program state P4 may be "1100", a bit pattern of the fifth program state P5 may be "1000", a bit pattern of the sixth program state P6 may be "0000", a bit pattern of the seventh program state P7 may be "0001", a bit pattern of the eighth program state P8 may be "0101", a bit pattern of the ninth program state P9 may be "0111", a bit pattern of the tenth program state P10 may be "0011", a bit pattern of the eleventh program state P11 may be "0010", a bit pattern of the twelfth program state P12 may be "1010", a bit pattern of the thirteenth program state P13 may be "1011", a bit pattern of the fourteenth program state P14 may be "1001", and a bit pattern of the fifteenth program state P15 may be "1101".

The values of the LSB, the ESB, the USB, and the MSB corresponding to each of the erase state "E" and the first to fifteenth program states P1 to P15 illustrated in FIG. 10 are presented as examples to help understand some example embodiments of the present inventive concepts, but example embodiments are not limited thereto. For example, the values of the LSB, the ESB, the USB, and the MSB corresponding to each of the first to fifteenth program states P1 to P15 may be variously changed.

The memory cells of the fifteenth program state P15 may have a highest threshold voltage distribution range among the erase state "E" and the first to fifteenth program states P1 to P15.

Referring to both FIGS. 4 and 10, according to some example embodiments, the E/D engine 124 may perform a first shaping encoding on the write data such that data corresponding to the fifteenth program state P15 among the erase state "E" and the first to fifteenth program states P1 to P15 decreases.

In some example embodiments, in the write data written as the LSB, the write data may be encoded such that the number of bits corresponding to the value of the LSB of the highest fifteenth program state P15 is decreased. For example, the write data may be encoded such that bits having a value of "1", which is the value of the LSB of the highest fifteenth program state P15, are decreased. For example, in the write data, some of the bits having a value of "1" may be converted to have a value of "0".

The value of the LSB of the erase state "E", the first program state P1, the fourth program state P4, the fifth program state P5, and the twelfth to fifteenth program states P12 to P15, among the erase state "E" and the first to fifteenth program states P1 to P15, is "1". When the write data is converted such that the number of bits having the value of "1" is decreased, the number of memory cells having the erase state "E", the first program state P1, the fourth program state P4, the fifth program state P5, and the twelfth to fifteenth program states P12 to P15 is decreased. In some example embodiments, since the number of bits having the value of "0" in the write data increases, the number of memory cells having the second and third program states P2 and P3, and the sixth to eleventh program states P6 to P11 increases.

In some example embodiments, in the write data written as the ESB, the write data may be encoded such that the number of bits corresponding to the value of the ESB of the highest fifteenth program state P15 is decreased. For example, the write data may be encoded such that the number of bits having a value of "1", which is the value of the ESB of the highest fifteenth program state P15, are decreased. For example, in the write data, some of the bits having a value of "1" may be converted to have a value of "0".

The value of the ESB of the erase state "E", the first to fourth program states P1 to P4, the eighth program state P8, and the ninth program state P9, among the erase state "E" and the first to fifteenth program states P1 to P15, matches the value of the ESB of the highest fifteenth program state P15, which is "1". Accordingly, the number of memory cells having the erase state "E", the first to fourth program states P1 to P4, the eighth program state P8, and the ninth program state P9 is decreased. In some example embodiments, the number of memory cells MC having the remaining program states excluding the erase state "E", the first to fourth program states P1 to P4, the eighth program state P8, and the ninth program state P9, among the erase state "E" and the first to fifteenth program states P1 to P15, increases.

As in the above description, according to some example embodiments, in the write data written in the memory cells as the USB, the write data may be encoded such that the number of bits corresponding to the value of the USB of the highest fifteenth program state P15 is decreased, and in the write data written in the memory cells as the MSB, the write data may be encoded such that the number of bits corresponding to the value of the MSB of the highest fifteenth program state P15 is decreased.

In some example embodiments, the first shaping encoding for the write data may be performed as a reference encoding based on the masking data MDATA. The masking data MDATA may be associated with encoded data of the lower data of the write data. For example, the masking data MDATA may be associated with the encoded data of the lower data and a bit pattern of the highest fifteenth program state P15.

For example, in the write data written as the LSB, the lower data may not exist. When the write data is LSB data, first masking data may be generated. The values of the bits included in the first masking data may be "1". The write data may be encoded such that the number of bits having the value of the LSB of the highest fifteenth program state P15 is decreased. After encoding, the first masking data may be updated as the second masking data based on the first masking data and the LSB data (e.g., the encoded data). For example, among the LSB data to be written (or written) into the memory cells MC, bits having a value of the LSB of the highest fifteenth program state P15 may be detected. The first masking data may be updated as the second masking data such that the bits corresponding to the detected bits have a value of "1" and the bits not corresponding to the detected bits have a value of "0".

For example, in the write data written as the ESB, reference encoding may be performed. In the example of the reference encoding, the write data may be encoded such that among the write data, bits corresponding to the bits having a value of "1" of the second masking data and bits having a value of "1", which is the value of the ESB of the highest fifteenth program state P15, are decreased. After the encoding, the second masking data may be updated based on the second masking data and the ESB data (e.g., the encoded data). For example, among the LSB data and the ESB data to be written (or written) into the memory cells MC, bits having the value of the LSB and the value of the ESB of the highest fifteenth program state P15 may be detected. For example, among the LSB data, bits having the value of the LSB of the highest fifteenth program state P15 may be written, and among the ESB data, positions having the value of the ESB of the highest fifteenth program state P15 may be detected. The second masking data may be updated as the third masking data such that the bits corresponding to the detected positions have a value of "1" and the bits not corresponding to the detected positions have a value of "0".

In some example embodiments, the second masking data may be updated based on the ESB data and the LSB data, which is the lower data of the write data.

As in the above description, according to some example embodiments, in the write data written as the USB, reference encoding may be performed. Among the write data, the write data may be encoded such that bits corresponding to the bits having a value of "1" of the third masking data and bits having a value of "0", which is the USB value of the highest fifteenth program state P15, are decreased. After encoding, the third masking data may be updated as a fourth masking data based on the third masking data and the USB data (e.g., the encoded data).

In some example embodiments, the third masking data may be updated based on the USB data, and the LSB data and ESB data, which are lower data of the write data.

As in the above description, according to some example embodiments, in the write data written as the MSB, reference encoding may be performed. Among the write data, the write data may be encoded such that bits corresponding to the bits having a value of "1" of the fourth masking data and bits having a value of "1", which is the USB value of the highest fifteenth program state P15, are decreased. In some example embodiments, after encoding, the fourth masking data may be deleted or the bits included in the fourth masking data may be initialized to have a value of "1".

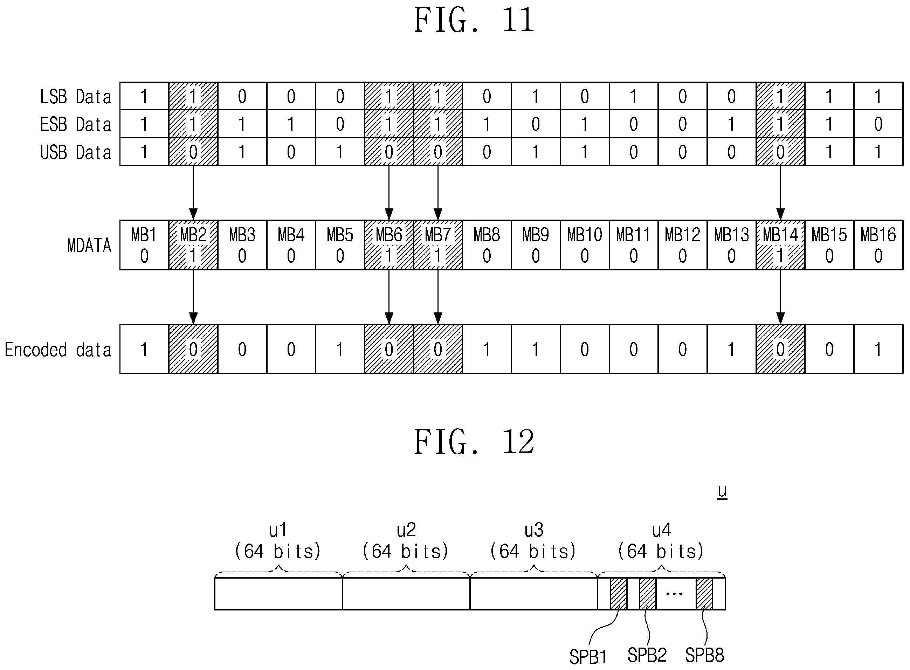

FIG. 11 illustrates an example of masking data for a first shaping encoding, according to some example embodiments. FIG. 11 assumes that the first shaping encoding is for the write data written as the MSB. In FIG. 11, the masking data MDATA may correspond to the fourth masking data in FIG. 10. In FIG. 11, it is assumed that the bit pattern of the fifteenth program state P15 is "1101".

Referring to FIGS. 4, 10, and 11, the first shaping encoding may be performed as a reference encoding based on the masking data MDATA. Among the write data, the write data may be encoded such that the bits corresponding to the bits having the value of "1" of the masking data MDATA and the bits having the value of "1", which is the MSB value of the highest fifteenth program state P15, are decreased.

For example, among the LSB data, the ESB data, and the USB data to be written (or written) to memory cells (e.g., memory cells corresponding to one page), the positions of bits having the LSB value, the ESB value, and the USB value of the fifteenth program state P15 may be detected. Among bits MB1 to MB16 included in the masking data MDATA, second, sixth, seventh, and fourteenth bits MB2, MB6, MB7, and MB14 corresponding to the detected positions may have a value of "1". The remaining bits MB1, MB3, MB4, MB5, MB8, MB9, MB10, MB11, MB12, MB13, MB15, and MB16 that do not correspond to the detected positions may have a value of "0". In the encoded data, the bits corresponding to the second, sixth, seventh, and fourteenth bits MB2, MB6, MB7, and MB14 of the masking data MDATA may have a value of "0" different from the value of the MSB of the fifteenth program state P15.

FIG. 12 illustrates an example of an alignment vector for a second shaping encoding, according to some example embodiments. In FIG. 12, it is assumed that the alignment vector "u" for the second shaping encoding is illustrated.

Referring to FIG. 1 and FIG. 12, the alignment vector "u" may include the first to fourth sub-vectors u1 to u4, the number of bits included in each of the first to fourth sub-vectors u1 to u4 may be 64, and the fourth sub-vector u4 may include first to eighth shaping parity bits SPB1 to SPB8.

In data bus conversion encoding, one shaping parity bit SPB is added for every eight data bits DBs or sixteen data bits DBs.

According to some example embodiments, the second shaping encoding may reduce power consumption due to transmission and reception of data between the nonvolatile memory device 110 and the memory controller 120 by using a small number of shaping parity bits SPBs. Therefore, the performance of the data bus conversion encoding may be improved.

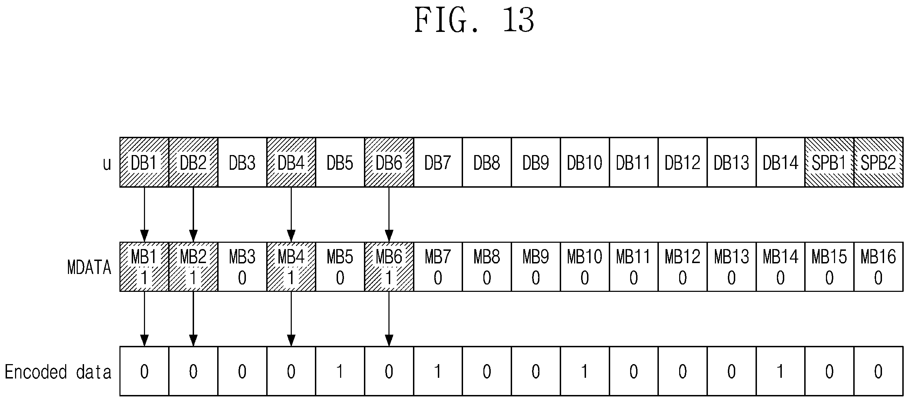

FIG. 13 illustrates an example of masking data for a second shaping encoding, according to some example embodiments. In FIG. 13, it is assumed that the alignment vector "u" is an updated alignment vector.

Referring to FIGS. 1, 4, and 13, the second shaping encoding may be performed as a reference encoding based on the masking data MDATA. The second shaping encoding may be performed by referencing the masking data MDATA such that bits having a value of "1" among the encoded data are decreased.

The E/D engine 124 may determine at least one bit (hereinafter referred to as a "candidate bit") whose bit value may be inverted as a result of the second shaping encoding among the alignment vector "u". For example, the E/D engine 124 may determine at least one candidate bit among the alignment vector "u". In some example embodiments, at least one candidate bit may be determined among the bits having a value of "1" among the alignment vector "u". In FIG. 13, the candidate bits may be first, second, fourth, and sixth data bits DB1, DB2, DB4, and DB6 among the bits included in the alignment vector "u".

The E/D engine 124 may generate the masking data MDATA based on the determined at least one candidate bit. The masking data MDATA may indicate the position of a candidate bit. For example, in the masking data MDATA, a bit having a value of "1" may indicate the position of a candidate bit, and a bit having a value of "0" may indicate the position of a bit that is not a candidate bit. In FIG. 13, first, second, fourth, and sixth bits MB1, MB2, MB4, and MB6 of the masking data MDATA may indicate the positions of the candidate bits.

The E/D engine 124 may perform the second shaping encoding based on the alignment vector "u" and the masking data MDATA. In the encoded data, the bits corresponding to the first, second, fourth, and sixth bits MB1, MB2, MB4, and MB6 of the masking data MDATA may have a value of "0".

In some example embodiments, the E/D engine 124 may determine at least one candidate bit of data to be transmitted and/or sent to the nonvolatile memory device 110.

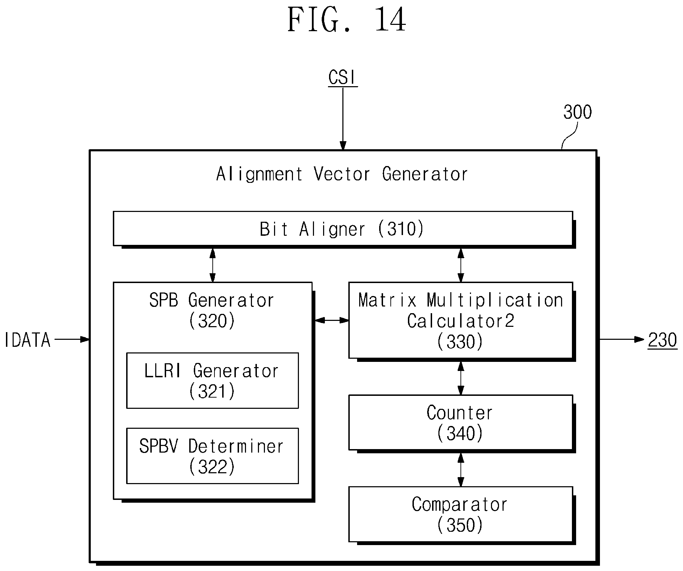

FIG. 14 illustrates an example of an alignment vector generator, according to some example embodiments. Referring to FIG. 5B and FIG. 14, an alignment vector generator 300 may include a bit aligner 310, a shaping parity bit (SPB) generator 320, a second matrix multiplication calculator 330, a counter 340, and a comparator 350. In FIG. 14, the bit aligner 310 and an LLR information generator 321 perform the same operations as the bit aligner 221 and the LLR information generator 222a of FIG. 5B. Therefore, for the convenience of description, additional descriptions are omitted to avoid redundancy.

A shaping parity bit value (SPBV) determiner 322 may generate one or more candidate sets each representing a combination of values of shaping parity bits. For example, the shaping parity bit value determiner 322 may generate a first candidate alignment vector CDu1 including a first combination of values of the shaping parity bits SPBs using a parity value search algorithm. The shaping parity bit value determiner 322 may generate a second candidate alignment vector CDu2 including a second combination of values of the shaping parity bits SPBs. As in the above description, in some example embodiments, the shaping parity bit value determiner 322 may generate a p-th candidate alignment vector CDup including a p-th combination (where "p" is a natural number greater than "1").

The second matrix multiplication calculator 330 may perform a matrix multiplication calculation on each of one or more candidate sets. For example, the second matrix multiplication calculator 330 may perform a second matrix multiplication calculation of the first candidate alignment vector CDu1 and the modified polar code-based generation matrix GM. The second matrix multiplication calculator 330 may perform a second matrix multiplication calculation of the second candidate alignment vector CDu2 and the modified polar code-based generation matrix GM. As in the above description, in some example embodiments, the second matrix multiplication calculator 330 may perform a second matrix multiplication calculation of the p-th candidate alignment vector CDup and the modified polar code-based generation matrix GM.

The counter 340 may count the number of bits satisfying a specific, or alternatively desired bit value based on the result of the second matrix multiplication calculation for each of the plurality of candidate alignment vectors.

For example, the counter 340 may count the number of bits having a value of "1" or "0" in the result of the second matrix multiplication calculation for each of the plurality of candidate alignment vectors. In some example embodiments, when the first shaping encoding is performed, the counter 340 may count the number of bits related to the fifteenth program state P15, which is the target state. In some example embodiments, when the second shaping encoding is performed, the counter 340 may count the number of bits having a value of "1".

The comparator 350 may compare the counting results of the counter 340. The comparator 350 may select one of one or more candidate sets based on the compared result. For example, when the first shaping encoding is performed, the comparator 350 may select the candidate alignment vector having the smallest number of bits related to the fifteenth program state among the first to p-th candidate alignment vectors CDu1 to CDup. For example, when the second shaping encoding is performed, the comparator 350 may select the candidate alignment vector having the smallest number of bits having a value of "1" among the first to p-th candidate alignment vectors CDu1 to CDup.

The comparator 350 may output the selected candidate alignment vector to the first matrix multiplication calculator 230.

In some example embodiments, the comparator 350 may output the result of the second matrix multiplication calculation with respect to the selected candidate alignment vector and the modified polar code-based generation matrix GM. For example, the first matrix multiplication calculator 230 may not perform the second matrix multiplication calculation on the data output from the comparator 350.

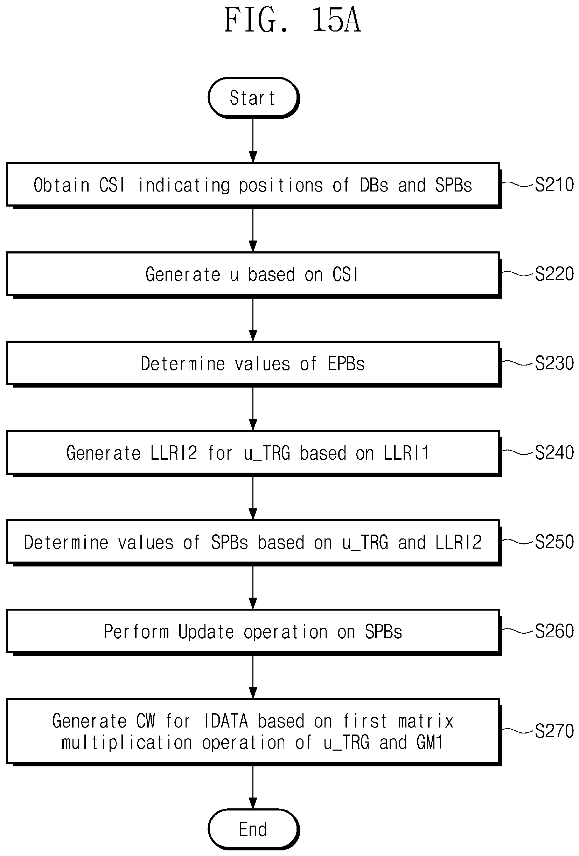

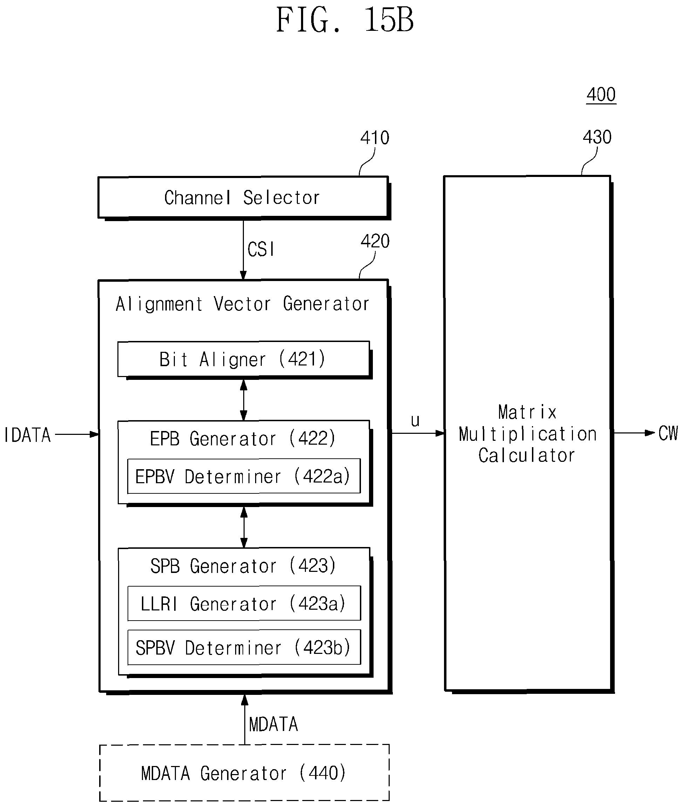

FIG. 15A illustrates an example of a flowchart for an operation of an encoder of the memory controller of FIG. 4 according to some example embodiments. FIG. 15B illustrates an encoder configured to perform operations according to a flowchart of FIG. 15A according to some example embodiments. Referring to FIGS. 15A and 15B, an encoder 400 may perform joint encoding that combines error correction encoding and shaping encoding.

For example, in operation S210, the encoder 400 may obtain the channel selection information CSI indicating the positions of the data bits DBs of the input data IDATA and the positions of the shaping parity bits SPBs. For example, a channel selector 410 of FIG. 15B may distinguish a plurality of channels into good channels and bad channels through channel polarization based on polar codes. A good channel may be used for the shaping parity bits SPBs, and a bad channel may be used for ECC parity bits EPBs and the data bits DBs of the input data IDATA. Positions of the data bits DBs and positions of the shaping parity bits SPBs may refer to the channels on which the data bits DBs and the shaping parity bits SPBs, respectively, are transmitted and/or sent.

In operation S220, the encoder 400 may generate the alignment vector "u" by aligning the data bits DBs, the ECC parity bits EPBs, and the shaping parity bits SPBs based on the channel selection information CSI. For example, a bit aligner 421 of FIG. 15B may receive the ECC parity bits EPBs having initial values from an ECC parity bit (EPB) generator 422, and may receive the shaping parity bits SPBs having initial values from a shaping parity bit generator 423. In some example embodiments, each of the initial values may be an arbitrary value. The bit aligner 421 may generate the alignment vector "u" by aligning the data bits DBs having specific values, the ECC parity bits EPBs having initial values, and the shaping parity bits SPBs having initial values.

In operation S230, the encoder 400 may determine the values of the ECC parity bits EPBs. For example, an ECC parity bit value determiner 422a of FIG. 15B may determine the values of the ECC parity bits EPBs based on a modified polar code-based generation matrix GM. For example, the ECC parity bit value (EPBV) determiner 422a may perform a matrix multiplication calculation of the generation matrix GM having a size of "n" x "n" and a transpose matrix of a parity check matrix HM having a size of "l" x "n" (where, "l" is a natural number greater than "1"). The ECC parity bit value determiner 422a may determine the values of the ECC parity bits EPBs based on the result of the matrix multiplication calculation of the generation matrix GM and the transpose matrix of the parity check matrix HM. For example, the alignment vector "u", the generation matrix GM, the transpose matrix of the parity check matrix HM may satisfy the following Equation 2.

[Equation 2]

$$u * GM * HM^T = 0$$

In Equation 2, "u" refers to the alignment vector "u", GM refers to the generation matrix GM, and $HM^T$ may refer to the transpose matrix of the parity check matrix HM.

In operation S240, the encoder 400 may generate the second LLR information LLRI2 for the target vector u_TRG including the shaping parity bits SPBs based on the first LLR (log likelihood ratio) information LLRI1 related to the alignment vector "u". The target vector u_TRG is a part of the alignment vector "u" and may include the shaping parity bits SPBs. Each of the first LLR information LLRI1 and the second LLR information LLRI2 may include a different number of LLR values. For example, an LLR information generator 423a of FIG. 15B may generate the second LLR information LLRI2 based on accumulating the first LLR information LLRI1. The LLR information generator 423a may generate the second LLR information LLRI2 including the first LLR information LLRI1 based on the accumulation calculation.

In operation S250, the encoder 400 may determine values of the shaping parity bits SPBs based on the target vector u_TRG and the second LLR information LLRI2. For example, a shaping parity bit value determiner 423b of FIG. 15B may determine the values of the shaping parity bits SPBs based on the target vector u_TRG and the second LLR information LLRI2.

For example, the shaping parity bit value determiner 423b may determine the values of the shaping parity bits SPBs from the target vector u_TRG and the second LLR information LLRI2 using a parity value search algorithm. In some example embodiments, the shaping parity bit value determiner 423b may determine the values of the shaping parity bits SPBs using a polar decoding algorithm. For example, the shaping parity bit value determiner 423b may determine the values of the shaping parity bits SPBs using an SC (successive cancellation) algorithm, a List SC (list successive cancellation) algorithm, a Brute Force Search algorithm, etc.

In operation S260, the encoder 400 may perform an update operation on the shaping parity bits SPBs based on the determined values. For example, the bit aligner 421 of FIG. 15B may receive the determined values from the shaping parity bit value determiner 423b. The bit aligner 421 may perform an update operation on the shaping parity bits SPBs based on the determined values. As a result of the performance, the values of the shaping parity bits SPBs may be updated from the initial values to the determined values.

In operation S270, after the update operation, the encoder 400 may generate the codeword CW with respect to the alignment vector "u" based on a first matrix multiplication calculation of the target vector u_TRG and the first generation matrix GM1. For example, a matrix multiplication calculator 430 of FIG. 15B may receive the alignment vector "u" from an alignment vector generator 420 after the update operation. The matrix multiplication calculator 430 may generate the codeword CW with respect to the alignment vector "u" based on the first matrix multiplication calculation of the target vector u_TRG which is a part of the alignment vector "u" and the first generation matrix GM1. The first generation matrix GM1 may refer to the sub-generation matrix SGM included in the generation matrix GM based on a modified polar code.

In some example embodiments, the encoder 400 may further include a masking data generator 440. The masking data generator 440 may correspond to the masking data generator 240 of FIG. 5B. Therefore, for the convenience of description, additional descriptions are omitted to avoid redundancy.

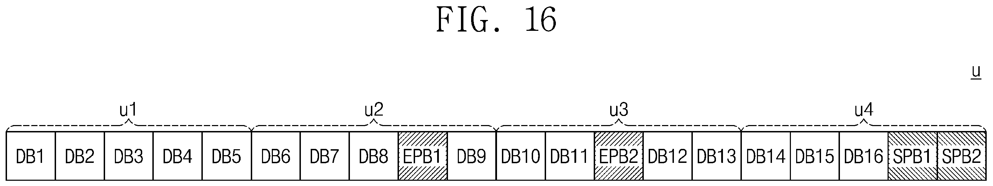

FIG. 16 illustrates an example of an alignment vector for joint encoding, according to some example embodiments.

Referring to FIG. 16, the alignment vector "u" may include the first to fourth sub-vectors u1 to u4. The first sub-vector u1 may include first to fifth data bits DB1 to DB5, the second sub-vector u2 may include sixth to eighth data bits DB6 to DB8, a first ECC parity bit EPB1, and a ninth data bit DB9, the third sub-vector u3 may include tenth and eleventh data bits DB10 and DB11, a second ECC parity bit EPB2, and twelfth and thirteenth data bits DB12 and DB13, and the fourth sub-vector u4 may include fourteenth to sixteenth data bits DB14 to DB16 and first and second shaping parity bits SPB1 and SPB2.

When the error correction encoding and the shaping encoding are performed sequentially there may be a problem that the performance of the shaping encoding is decreased since ECC parity bits are not subjected to the shaping encoding. According to some example embodiments, the joint encoding may reduce or prevent performance degradation due to sequential operation of the error correction encoding and the shaping encoding by combining the error correction encoding and the shaping encoding.

FIG. 17 illustrates an example for describing an operation of shaping decoding, according to some example embodiments.

Referring to FIG. 1, FIG. 6, FIG. 8, and FIG. 17, the E/D engine 124 may perform shaping decoding on third data DATA3. The shaping decoded data may be identical to the data before the shaping encoding is performed. For example, the E/D engine 124 may restore the data by performing the shaping decoding.

The shaping decoding may be performed in a similar manner to the shaping encoding. For example, the shaping decoding may be performed based on a third matrix multiplication calculation of a target sub-data SD_TRG and the sub-generation matrix SGM.

In FIG. 17, data DATA may include "n" bits. The third data DATA3 may include first sub-data to m-th sub-data SD1 to SDm. Each of the first sub-data to the m-th sub-data SD1 to SDm may include "k" bits.

The first sub-data to the m-th sub-data SD1 to SDm may be arranged sequentially in the row direction within the third data DATA3. The m-th sub-data SDm arranged last among the first sub-data to the m-th sub-data SD1 to SDm may be the target sub-data SD_TRG.

In some example embodiments, the third data DATA3 may be related to data (e.g., the codeword CW) on which the shaping encoding is performed. For example, the third data DATA3 may be read data output from the nonvolatile memory device 110. For example, the memory controller 120 may transmit and/or send the data on which the shaping encoding is performed to the non-

volatile memory device 110. The nonvolatile memory device 110 may write data received from the memory controller 120. The nonvolatile memory device 110 may perform a read operation on the written data and may output the read data as the third data DATA3 to the memory controller 120.

For example, the third data DATA3 may be data on which the error correction decoding is performed. In some example embodiments, the memory controller 120 may perform the error correction encoding on data on which the shaping encoding is performed. The memory controller 120 may transmit and/or send the data on which the error correction encoding is performed to the nonvolatile memory device 110. The nonvolatile memory device 110 may write data received from the memory controller 120. The nonvolatile memory device 110 may perform a read operation on the written data and may output the read data to the memory controller 120. The memory controller 120 may perform the error correction decoding on data output from the nonvolatile memory device 110. The memory controller 120 may perform the shaping decoding on data on which the error correction decoding is performed.

According to some example embodiments, the memory controller 120 may perform the joint encoding that combines the shaping encoding and the error correction encoding. The memory controller 120 may transmit and/or send data on which the joint encoding is performed to the nonvolatile memory device 110. The nonvolatile memory device 110 may write data received from the memory controller 120. The nonvolatile memory device 110 may perform a read operation on the written data and may output the read data to the memory controller 120. The memory controller 120 may perform the error correction decoding on data output from the nonvolatile memory device 110. The memory controller 120 may perform the shaping decoding on data on which the error correction decoding is performed.

However, example embodiments are not limited thereto, and in some example embodiments the third data DATA3 may be related to the shaping-encoded data and may represent various data received from the nonvolatile memory device 110.

In some example embodiments, when the error correction decoding and the shaping decoding are performed, the memory controller 120 may perform iteration decoding. For example, when an error is detected through a CRC (cyclic redundancy check) check, the memory controller 120 may iterate the error correction decoding and the shaping decoding until the termination condition of the iteration decoding is satisfied. In some example embodiments, the termination condition of the iteration decoding may be set in advance. For example, when the number of iteration decoding reaches the maximum number of iterations, the iteration decoding may be terminated. For example, when an error is not detected through the CRC check, the iteration decoding may be terminated.

FIG. 18 illustrates an example of a result of shaping decoding, according to some example embodiments. In FIG. 18, it is assumed that encoded data EDATA includes the first sub-data to the fourth sub-data SD1 to SD4.

Referring to FIG. 1, FIG. 8, FIG. 17, and FIG. 18, the shaping decoding may be performed based on the third matrix multiplication calculation of the fourth sub-data SD4, which is the target sub-data SD_TRG, and the sub-generation matrix SGM. As a result of the shaping decoding, decoded data DDATA may be generated. The decoded data DDATA may include first decoding data to fourth decoding data DD1 to DD4.

For example, the first decoding data DD1 may be obtained by a logical calculation of a result R3 of the third matrix multiplication calculation of the fourth sub-data SD4 and the sub-generation matrix SGM and the first sub-data SD1. The second decoding data DD2 may be obtained by a logical calculation of the result R3 of the third matrix multiplication calculation and the second sub data SD2. The third decoding data DD3 may be obtained by a logical calculation of the result R3 of the third matrix multiplication calculation and the third sub data SD3. The fourth decoding data DD4 may be the result R3 of the third matrix multiplication calculation.

In some example embodiments, the logical calculation may represent an XOR logical calculation.

As in FIG. 18, the decoded data DDATA may be generated based on the third matrix multiplication calculation of the target sub-data SD_TRG and the sub-generation matrix SGM, and the logical calculation of each of the remaining sub-data SD1 to SD3 excluding the target sub-data SD_TRG among the plurality of sub-data and the result R3 of the third matrix multiplication calculation.

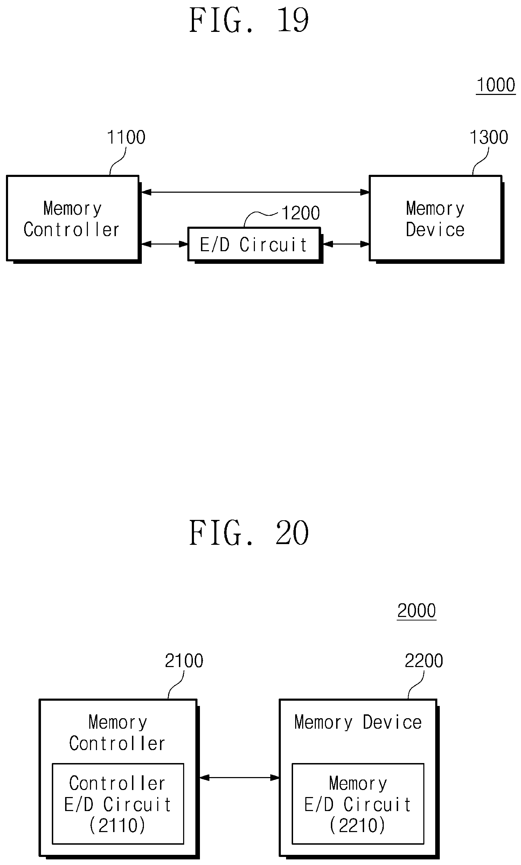

FIG. 19 illustrates a memory system, according to some example embodiments. Referring to FIG. 19, a memory system 1000 may include a memory controller 1100, an E/D circuit 1200, and a memory device 1300. The memory controller 1100 may store data into the memory device 1300 and/or may read data stored in the memory device 1200.

In some example embodiments, the E/D circuit 1200 may be located in a data path between the memory controller 1100 and the memory device 1300. The E/D circuit 1200 may be configured to perform the shaping encoding or the shaping decoding on data transmitted and/or sent and received between the memory controller 1100 and the memory device 1300. In some example embodiments, the E/D circuit 1200 may be configured to perform error correction encoding or error correction decoding on data transmitted and/or sent and received between the memory controller 1100 and the memory device 1300.

In some example embodiments, the E/D circuit 1200 may perform the shaping encoding and/or the shaping decoding based on the operating methods described with reference to FIGS. 1 to 18.

FIG. 20 is a block diagram illustrating a memory system according to some example embodiments. Referring to FIG. 20, a memory system 2000 may include a memory controller 2100 and a memory device 2200. The memory controller 2100 may include a controller E/D circuit 2110. The controller E/D circuit 2110 may perform shaping encoding on write data to be stored in the memory device 2200 and shaping decoding on read data received from the memory device 2200. In some example embodiments, the controller E/D circuit 2110 may perform error correction encoding on write data to be stored in the memory device 2200 and error correction decoding on read data received from the memory device 2200.

The memory device 2200 may include a memory E/D circuit 2210. The memory E/D circuit 2210 may perform shaping decoding on write data received from the memory controller 2100 and shaping encoding on read data stored in the memory device 2200. In some example embodiments, the memory E/D circuit 2210 may perform error correction decoding on write data received from the memory controller 2100 and error correction encoding on read data stored in the memory device 2200.

In some example embodiments, each of the controller E/D circuit 2110 and the memory E/D circuit 2210 may perform shaping encoding or shaping decoding based on the methods described with reference to FIGS. 1 to 18.

In some example embodiments, components according to the present disclosure are described by using the terms "first", "second", "third", and the like. However, the terms "first", "second", "third", and the like may be used to distinguish components from each other and do not limit the present disclosure. For example, the terms "first", "second", "third", and the like do not involve an order or a numerical meaning of any form.

According to some example embodiments, a storage device may reduce the complexity of a calculation based on a modified polar code-based calculation. In some example embodiments, since error correction encoding may be performed simultaneously with data shaping encoding, a storage device and an operating method of the storage device with improved performance and improved reliability are provided.

As described herein, any devices, electronic devices, modules, units, and/or portions thereof according to any of the example embodiments, and/or any portions thereof may include, may be included in, and/or may be implemented by one or more instances of processing circuitry such as hardware including logic circuits; a hardware/software combination such as a processor executing software; or a combination thereof. For example, the processing circuity more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a solid state drive (SSD), storing a program of instructions, and a processor (e.g., CPU) configured to execute the program of instructions to implement the functionality and/or methods performed by some or all of any devices, electronic devices, modules, units, and/or portions thereof according to any of the example embodiments.

As described herein, any of the memories described herein may be a nonvolatile memory, such as a flash memory, a phase-change random access memory (PRAM), a magnetoresistive RAM (MRAM), a resistive RAM (ReRAM), or a ferro-electric RAM (FRAM), or a volatile memory, such as a static RAM (SRAM), a dynamic RAM (DRAM), or a synchronous DRAM (SDRAM).

As described herein, any or all of the elements described with reference to the figures may communicate with any or all other elements described with reference to figures. For example, any element may engage in one-way and/or two-way and/or broadcast communication with any or all other elements in the figures, to transfer and/or exchange and/or receive information such as but not limited to data and/or commands, in a manner such as in a serial and/or parallel manner, via a bus such as a wireless and/or a wired bus (not illustrated). The information may be in encoded various formats, such as in an analog format and/or in a digital format.

The above descriptions are some example embodiments for carrying out the present inventive concepts. Some example embodiments in which a design is changed simply, or which are easily changed may be included in the present inventive concepts as well as some example embodiments described above. According to some example embodiments, technologies that are easily changed and implemented by using the above example embodiments may be included in the present inventive concepts.

Embodiments are set out in the following clauses:

Clause 1: An operating method of a storage device which includes a nonvolatile memory device and a memory controller configured to control the nonvolatile memory device, the method comprising:

obtaining by the memory controller, channel selection information indicating positions of data bits included in input data and positions of shaping parity bits;

generating, by the memory controller, an alignment vector by aligning the data bits and the shaping parity bits having arbitrary values, based on the channel selection information;

generating based on first log likelihood ratio (LLR) information related to the alignment vector, by the memory controller, second LLR information for a target vector including the shaping parity bits;

determining, by the memory controller, values of the shaping parity bits, based on the target vector and the second LLR information;

performing, by the memory controller, an update operation on the shaping parity bits, based on the determined values; and

generating, by the memory controller, a codeword with respect to the input data, based on a first matrix multiplication calculation of the target vector and a first generation matrix after the update operation is performed.

Clause 2: The method of clause 1, wherein the alignment vector includes a plurality of sub-vectors which are sequentially arranged,

wherein the target vector indicates a sub-vector arranged last among the plurality of sub-vectors, and

wherein the generating of the codeword with respect to the input data includes performing a logical calculation on each of a remaining sub-vectors excluding the target vector among the plurality of sub-vectors and a result of the first matrix multiplication calculation.

Clause 3: The method of clause 2, wherein the first matrix multiplication calculation and the logical calculation are performed based on a second matrix multiplication calculation with respect to the alignment vector after the update operation and a second generation matrix including the first generation matrix,

wherein the second generation matrix has a size of "n" x "n", where "n" is a number of bits included in the alignment vector,

wherein the second generation matrix includes first to m-th column matrices, where "m" is a number of the sub-vectors, and

wherein the first generation matrix has a size of "k" x "k", where "k" is a number of bits included in each of the plurality of sub-vectors.

Clause 4: The method of any preceding clause, wherein the generating of the second LLR information includes generating probability values included in the second LLR information including the first LLR information, based on an accumulation calculation on probability values included in the first LLR information.

Clause 5: The method of any preceding clause, wherein the nonvolatile memory device includes a plurality of memory cells, and

wherein the determining of the values of the shaping parity bits is performed to reduce a number of memory cells programmed to a target state among program states of the plurality of memory cells.

Clause 6: The method of clause 5, further comprising:

> writing, by the nonvolatile memory device, data related to the codeword;
> reading, by the nonvolatile memory device, the written data; and
> restoring, by the memory controller, the input data based on a third matrix multiplication calculation of target data among the read data and the first generation matrix.

Clause 7: The method of any preceding clause, wherein the determining of the values of the shaping parity bits is performed to reduce a number of bits having a first value among bits of the codeword.

Clause 8: The method of clause 7, further comprising:

> receiving, by the nonvolatile memory device, data related to the codeword from the memory controller; and
> restoring, by the nonvolatile memory device, the received data to the input data, based on a third matrix multiplication calculation of target data among the received data and the first generation matrix.

Clause 9: An operating method of a storage device which includes a nonvolatile memory device and a memory controller configured to control the nonvolatile memory device, the method comprising:

> obtaining, by the memory controller, channel selection information indicating positions of data bits included in input data, positions of error correction code (ECC) parity bits, and positions of shaping parity bits;
> generating, by the memory controller, an alignment vector by aligning the data bits, the ECC parity bits, and the shaping parity bits, based on the channel selection information;
> determining, by the memory controller, values of the ECC parity bits;
> generating based on first log likelihood ratio, LLR, information related to the alignment vector, by the memory controller, second LLR information for a target vector including the shaping parity bits;
> determining, by the memory controller, values of the shaping parity bits, based on the target vector and the second LLR information;
performing, by the memory controller, an update operation on the shaping parity bits, based on the determined values; and
generating, by the memory controller, a codeword with respect to the input data, based on a first matrix multiplication calculation of the target vector and a first generation matrix after the update operation is performed.

Clause 10: The method of clause 9, wherein the alignment vector includes a plurality of sub-vectors which are sequentially arranged,

> wherein the target vector indicates a sub-vector arranged last among the plurality of sub-vectors, and
> wherein the generating of the codeword with respect to the input data includes performing a logical calculation on each of a remaining sub-vectors excluding the target vector among the plurality of sub-vectors and a result of the first matrix multiplication.

Clause 11: The method of clause 10, wherein the first matrix multiplication calculation and the logical calculation are performed based on a second matrix multiplication calculation with respect to the alignment vector after the update operation and a second generation matrix including the first generation matrix,

> wherein the second generation matrix has a size of "n" x "n", where "n" is a number of bits included in the alignment vector,
> wherein the second generation matrix includes first to m-th column matrices, where "m" is a number of the sub-vectors, and
> wherein the first generation matrix has a size of "k" x "k", where "k" is a number of bits included in each of the plurality of sub-vectors.

Clause 12: The method of any of clauses 9 to 11 wherein the generating of the second LLR information includes generating probability values included in the second LLR information including the first LLR information, based on an accumulation calculation on probability values included in the first LLR information.

Clause 13: The method of any of clauses 9 to 12, wherein the nonvolatile memory device includes a plurality of memory cells, and
wherein the determining the values of the shaping parity bits is performed to reduce a number of memory cells programmed to a target state among program states of the plurality of memory cells.

Clause 14: The method of clause 13, further comprising:

writing, by the nonvolatile memory device, data related to the codeword;
reading, by the nonvolatile memory device, the written data;
performing, by the memory controller, an error correction decoding on the read data; and
restoring, by the memory controller, the input data based on a third matrix multiplication calculation of target data among the error correction decoded data and the first generation matrix.

Clause 15: A storage device, comprising:

a nonvolatile memory device; and
a memory controller configured to
control the nonvolatile memory device to
obtain channel selection information indicating positions of data bits included
in input data and positions of shaping parity bits,
generate an alignment vector by aligning the data bits and the shaping parity
bits based on the channel selection information,

generate, based on first log likelihood ratio (LLR) information related to the alignment vector, second LLR information for a target vector including the shaping parity bits,
determine values of the shaping parity bits based on the target vector and the second LLR information,
perform an update operation on the shaping parity bits based on the determined values, and
generate a codeword with respect to the input data based on a first matrix multiplication calculation of the target vector and a first generation matrix.

**Claims**

1. An operating method of a storage device (100) which includes a nonvolatile memory device (110) and a memory controller (120) configured to control the nonvolatile memory device (110), the method comprising:

obtaining (S110), by the memory controller (120), channel selection information indicating positions of data bits included in input data and positions of shaping parity bits;
generating (S120), by the memory controller (120), an alignment vector by aligning the data bits and the shaping parity bits having arbitrary values, based on the channel selection information;
generating (S130) based on first log likelihood ratio, LLR, information related to the alignment vector, by the memory controller (120), second LLR information for a target vector including the shaping parity bits;
determining (S140), by the memory controller (120), values of the shaping parity bits, based on the target vector and the second LLR information;
performing (S150), by the memory controller (120), an update operation on the shaping parity bits, based on the determined values; and
generating (S160), by the memory controller (120), a codeword with respect to the input data, based on a first matrix multiplication calculation of the target vector and a first generation matrix after the update operation is performed.

2. The method of claim 1, wherein the alignment vector includes a plurality of sub-vectors which are sequentially arranged,

wherein the target vector indicates a sub-vector arranged last among the plurality of sub-vectors, and
wherein the generating (S160) of the codeword with respect to the input data includes performing a logical calculation on each of the remaining sub-vectors excluding the target vector among the plurality of sub-vectors and a result of the first matrix multiplication calculation.

3. The method of claim 2, wherein the first matrix multiplication calculation and the logical calculation are performed based on a second matrix multiplication calculation with respect to the alignment vector after the update operation and a second generation matrix including the first generation matrix,

wherein the second generation matrix has a size of "n" x "n", where "n" is a number of bits included in the alignment vector,
wherein the second generation matrix includes first to m-th column matrices, where "m" is a number of the sub-vectors, and
wherein the first generation matrix has a size of "k" x "k", where "k" is a number of bits included in each of the plurality of sub-vectors.

4. The method of any preceding claim, wherein the generating (S130) of the second LLR information includes generating probability values included in the second LLR information including the first LLR information, based on an accumulation calculation on probability values included in the first LLR information.

5. The method of any preceding claim, wherein the nonvolatile memory device (110) includes a plurality of memory cells, and
wherein the determining (S140) of the values of the shaping parity bits reduces a number of memory cells programmed to a target state among program states of the plurality of memory cells.

6. The method of claim 5, further comprising:

writing, by the nonvolatile memory device (110), data related to the codeword;
reading, by the nonvolatile memory device (110), the written data; and
restoring, by the memory controller (120), the input data based on a third matrix multiplication calculation of target data among the read data and the first generation matrix.

7. The method of any preceding claim, wherein the determining (S140) of the values of the shaping parity bits reduces a number of bits having a first value among bits of the codeword.

8. The method of claim 7, further comprising:

receiving, by the nonvolatile memory device (110), data related to the codeword from the memory controller (120); and
restoring, by the nonvolatile memory device (110), the received data to the input data, based on a third matrix multiplication calculation of target data among the received data and the first generation matrix.

9. The operating method of claim 1,

wherein the channel selection information further indicates positions of error correction code, ECC, parity bits; and
the method further comprises determining (S230), by the memory controller (120), values of the ECC parity bits.

10. The method of claim 9, wherein the alignment vector includes a plurality of sub-vectors which are sequentially arranged,

wherein the target vector indicates a sub-vector arranged last among the plurality of sub-vectors, and
wherein the generating (S270) of the codeword with respect to the input data includes performing a logical calculation on each of the remaining sub-vectors excluding the target vector among the plurality of sub-vectors and a result of the first matrix multiplication.

11. The method of claim 10, wherein the first matrix multiplication calculation and the logical calculation are performed based on a second matrix multiplication calculation with respect to the alignment vector after the update operation and a second generation matrix including the first generation matrix,

wherein the second generation matrix has a size of "n" x "n", where "n" is a number of bits included in the alignment vector,
wherein the second generation matrix includes first to m-th column matrices, where "m" is a number of the sub-vectors, and
wherein the first generation matrix has a size of "k" x "k", where "k" is a number of bits included in each of the plurality of sub-vectors.

12. The method of any of claims 9 to 11 wherein the generating (S240) of the second LLR information includes generating probability values included in the second LLR information including the first LLR information, based on an accumulation calculation on probability values included in the first LLR information.

13. The method of any of claims 9 to 12, wherein the nonvolatile memory device (110) includes a plurality of memory cells, and
wherein the determining (S250) the values of the shaping parity bits reduces a number of memory cells programmed to a target state among program states of the plurality of memory cells.

14. The method of claim 13, further comprising:

writing, by the nonvolatile memory device (110), data related to the codeword;
reading, by the nonvolatile memory device (110), the written data;
performing, by the memory controller (120), an error correction decoding on the read data; and
restoring, by the memory controller (120), the input data based on a third matrix multiplication calculation of target data among the error correction decoded data and the first generation matrix.

15. A storage device (100), comprising:

a nonvolatile memory device (110); and
a memory controller (120) configured to control the nonvolatile memory device (110) to:

obtain (S110) channel selection information indicating positions of data bits included in input data and positions of shaping parity bits,
generate (S120) an alignment vector by aligning the data bits and the shaping parity bits based on the channel selection information,

generate (S130), based on first log likelihood ratio, LLR, information related to the alignment vector, second LLR information for a target vector including the shaping parity bits,

determine (S140) values of the shaping parity bits based on the target vector and the second LLR information,

perform (S150) an update operation on the shaping parity bits based on the determined values, and

generate (S160) a codeword with respect to the input data based on a first matrix multiplication calculation of the target vector and a first generation matrix.

# FIG. 1

# FIG. 2

# FIG. 3

BLKa

# FIG. 4

# FIG. 5A

```
        ┌─────────┐
        │  Start  │
        └─────────┘
             │
             ▼
┌──────────────────────────────────────────────┐
│  Obtain CSI indicating positions of DBs and SPBs │──── S110
└──────────────────────────────────────────────┘
             │
             ▼
┌──────────────────────────────────────────────┐
│           Generate u based on CSI            │──── S120
└──────────────────────────────────────────────┘
             │
             ▼
┌──────────────────────────────────────────────┐
│     Generate LLRI2 for u_TRG based on LLRI1   │──── S130
└──────────────────────────────────────────────┘
             │
             ▼
┌──────────────────────────────────────────────┐
│  Determine values of SPBs based on u_TRG and LLRI2 │──── S140
└──────────────────────────────────────────────┘
             │
             ▼
┌──────────────────────────────────────────────┐
│         Perform Update operation on SPBs      │──── S150
└──────────────────────────────────────────────┘
             │
             ▼
┌──────────────────────────────────────────────┐
│  Generate CW for IDATA based on first matrix   │──── S160
│  multiplication operation of u_TRG and GM1     │
└──────────────────────────────────────────────┘
             │
             ▼
        ┌─────────┐
        │   End   │
        └─────────┘
```

# FIG. 5B

# FIG. 6

# FIG. 7

# FIG. 8

GM

# FIG. 9

# FIG. 10

| | E | P1 | P2 | P3 | P4 | P5 | P6 | P7 | P8 | P9 | P10 | P11 | P12 | P13 | P14 | P15 |
|------|---|----|----|----|----|----|----|----|----|----|-----|-----|-----|-----|-----|-----|
| LSB | 1 | 1 | 0 | 0 | 1 | 1 | 0 | 0 | 0 | 0 | 0 | 0 | 1 | 1 | 1 | 1 |
| ESB | 1 | 1 | 1 | 1 | 1 | 0 | 0 | 0 | 1 | 1 | 0 | 0 | 0 | 0 | 0 | 1 |
| USB | 1 | 1 | 1 | 0 | 0 | 0 | 0 | 0 | 0 | 1 | 1 | 1 | 1 | 1 | 0 | 0 |
| MSB | 1 | 0 | 0 | 0 | 0 | 0 | 0 | 1 | 1 | 1 | 1 | 0 | 0 | 1 | 1 | 1 |

EP 4 746 301 A1

# FIG. 11

| | | | | | | | | | | | | | | | |
|---|---|---|---|---|---|---|---|---|---|---|---|---|---|---|---|
| LSB Data | 1 | 1 | 0 | 0 | 0 | 1 | 1 | 0 | 1 | 0 | 1 | 0 | 0 | 1 | 1 | 1 |
| ESB Data | 1 | 1 | 1 | 1 | 0 | 1 | 1 | 1 | 0 | 1 | 0 | 0 | 1 | 1 | 1 | 0 |
| USB Data | 1 | 0 | 1 | 0 | 1 | 0 | 0 | 0 | 1 | 1 | 0 | 0 | 0 | 0 | 1 | 1 |

| | | | | | | | | | | | | | | | |
|---|---|---|---|---|---|---|---|---|---|---|---|---|---|---|---|
| MDATA | MB1 0 | MB2 1 | MB3 0 | MB4 0 | MB5 0 | MB6 1 | MB7 1 | MB8 0 | MB9 0 | MB10 0 | MB11 0 | MB12 0 | MB13 0 | MB14 1 | MB15 0 | MB16 0 |

| | | | | | | | | | | | | | | | |
|---|---|---|---|---|---|---|---|---|---|---|---|---|---|---|---|
| Encoded data | 1 | 0 | 0 | 0 | 1 | 0 | 0 | 1 | 1 | 0 | 0 | 0 | 1 | 0 | 0 | 1 |

# FIG. 12

FIG. 13

EP 4 746 301 A1

| u | DB1 | DB2 | DB3 | DB4 | DB5 | DB6 | DB7 | DB8 | DB9 | DB10 | DB11 | DB12 | DB13 | DB14 | SPB1 | SPB2 |
|---|-----|-----|-----|-----|-----|-----|-----|-----|-----|------|------|------|------|------|------|------|

| MDATA | MB1 1 | MB2 1 | MB3 0 | MB4 1 | MB5 0 | MB6 1 | MB7 0 | MB8 0 | MB9 0 | MB10 0 | MB11 0 | MB12 0 | MB13 0 | MB14 0 | MB15 0 | MB16 0 |
|-------|-------|-------|-------|-------|-------|-------|-------|-------|-------|--------|--------|--------|--------|--------|--------|--------|

| Encoded data | 0 | 0 | 0 | 0 | 1 | 0 | 1 | 0 | 0 | 1 | 0 | 0 | 0 | 1 | 0 | 0 |
|--------------|---|---|---|---|---|---|---|---|---|---|---|---|---|---|---|---|

# FIG. 14

CSI

300

**Alignment Vector Generator**

Bit Aligner (310)

SPB Generator (320)
- LLRI Generator (321)
- SPBV Determiner (322)

Matrix Multiplication Calculator2 (330)

Counter (340)

Comparator (350)

IDATA →

→ 230

# FIG. 15A

```
                        ┌─────────┐
                        │  Start  │
                        └─────────┘
                             │
                             ▼
┌──────────────────────────────────────────────────────┐
│   Obtain CSI indicating positions of DBs and SPBs     │──S210
└──────────────────────────────────────────────────────┘
                             │
                             ▼
┌──────────────────────────────────────────────────────┐
│              Generate u based on CSI                  │──S220
└──────────────────────────────────────────────────────┘
                             │
                             ▼
┌──────────────────────────────────────────────────────┐
│              Determine values of EPBs                 │──S230
└──────────────────────────────────────────────────────┘
                             │
                             ▼
┌──────────────────────────────────────────────────────┐
│        Generate LLRI2 for u_TRG based on LLRI1        │──S240
└──────────────────────────────────────────────────────┘
                             │
                             ▼
┌──────────────────────────────────────────────────────┐
│  Determine values of SPBs based on u_TRG and LLRI2    │──S250
└──────────────────────────────────────────────────────┘
                             │
                             ▼
┌──────────────────────────────────────────────────────┐
│            Perform Update operation on SPBs           │──S260
└──────────────────────────────────────────────────────┘
                             │
                             ▼
┌──────────────────────────────────────────────────────┐
│      Generate CW for IDATA based on first matrix      │──S270
│       multiplication operation of u_TRG and GM1       │
└──────────────────────────────────────────────────────┘
                             │
                             ▼
                        ┌─────────┐
                        │   End   │
                        └─────────┘
```

# FIG. 15B

EP 4 746 301 A1

# FIG. 16

| u1 | | | | | u2 | | | | | u3 | | | | | u4 | | | |
| DB1 | DB2 | DB3 | DB4 | DB5 | DB6 | DB7 | DB8 | EPB1 | DB9 | DB10 | DB11 | EPB2 | DB12 | DB13 | DB14 | DB15 | DB16 | SPB1 | SPB2 |

u

# FIG. 17

DATA3
(n bits)

| | | ... | |
|---|---|---|---|

SD1
(k bits)

SD2
(k bits)

SDm
(k bits)

↑
SD_TRG

# FIG. 18

# FIG. 19

1000

1100

1300

Memory
Controller

~1200

E/D Circuit

Memory
Device

# FIG. 20

2000

2100

2200

Memory
Controller

Controller
E/D Circuit
(2110)

Memory Device

Memory
E/D Circuit
(2210)

# EP 4 746 301 A1

Europäisches Patentamt
European Patent Office
Office européen des brevets

**Application Number**

EP 25 18 9702

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/157672 A1 (SEOL CHANGKYU [KR] ET AL) 27 May 2021 (2021-05-27) | 1,5-9, 13-15 | INV.<br>H03M13/13 |
| Y | * the whole document * | 2-4, 10-12 | G06F11/10<br>H03M13/00<br>H04L1/00 |
| | ----- | | |
| Y | ONURCAN ISCAN ET AL: "Shaped Polar Codes for Higher Order Modulation", IEEE COMMUNICATIONS LETTERS., vol. 22, no. 2, 1 February 2018 (2018-02-01), pages 252-255, XP055462442, US ISSN: 1089-7798, DOI: 10.1109/LCOMM.2017.2766621 * section II * | 2-4, 10-12 | |
| | ----- | | |
| A | ISCAN ONURCAN ET AL: "Probabilistic Shaping Using 5G New Radio Polar Codes", IEEE ACCESS, vol. 7, 7 February 2019 (2019-02-07), pages 22579-22587, XP011712112, DOI: 10.1109/ACCESS.2019.2898103 [retrieved on 2019-02-27] * sections V & V.A * | 1-15 | |
| | ----- | | |

**TECHNICAL FIELDS SEARCHED (IPC)**

H03M
G06F
H04L

The present search report has been drawn up for all claims

| Place of search | Date of completion of the search | Examiner |
|---|---|---|
| Munich | 28 November 2025 | Wu, Zifeng |

EPO FORM 1503 03.82 (P4C01)

## ANNEX TO THE EUROPEAN SEARCH REPORT
## ON EUROPEAN PATENT APPLICATION NO.

EP 25 18 9702

This annex lists the patent family members relating to the patent documents cited in the above-mentioned European search report.
The members are as contained in the European Patent Office EDP file on
The European Patent Office is in no way liable for these particulars which are merely given for the purpose of information.

28-11-2025

| Patent document cited in search report | Publication date | Patent family member(s) | Publication date |
|---|---|---|---|
| US 2021157672 A1 | 27-05-2021 | CN 112837738 A<br>KR 20210062845 A<br>US 2021157672 A1 | 25-05-2021<br>01-06-2021<br>27-05-2021 |

EPO FORM P0459

For more details about this annex : see Official Journal of the European Patent Office, No. 12/82